# EUROPEAN PATENT APPLICATION

(11) **EP 4 534 493 A1**
(43) Date of publication of application: **09.04.2025**
(21) Application number: 24182230.3
(22) Date of filing: 14.06.2024
(51) Int. Cl.: C03C 15/00, C03C 17/34, C03C 23/00, G03F 7/00, B23K 26/064, B23K 26/55

(54) **METHOD FOR PRODUCING A TEMPERATURE-CONTROLLING HOLLOW STRUCTURE IN A SUBSTRATE USING A PROCESSING LIGHT BEAM**

(30) Priority: 14.06.2023 DE 102023205564
(71) Applicant: Carl Zeiss SMT GmbH, 73447 Oberkochen (DE)
(72) Inventor: Faas, Sebastian, 73447 Oberkochen (DE); Freimann, Rolf, 73447 Oberkochen (DE); Gruner, Toralf, 73447 Oberkochen (DE); Ruck, Simon, 73447 Oberkochen (DE); Seifert, Andreas, 73447 Oberkochen (DE); Suleiman, Samer, 73447 Oberkochen (DE); Ullsperger, Tobias, 73447 Oberkochen (DE); Weber, Rudolf, 3006 Bern (CH); Zipfel, Jonas, 73447 Oberkochen (DE); Gatzen, Caren, 73447 Oberkochen (DE)
(74) Representative: Ostertag & Partner Patentanwälte mbB

(57) **Abstract**

In the case of a method for producing a temperature-controlling hollow structure in a substrate, in particular in a mirror substrate of an EUV projection exposure apparatus or another semiconductor technology apparatus, first of all a substrate (12) consisting of a substrate material is provided. The substrate (12) is surveyed in order to ascertain where gas bubbles or other inclusions (52) are in the substrate (12). Then, a temperature-controlling hollow structure, which may be e.g. a cooling channel (22), is worked into the substrate (12) by focusing a processing light beam (34) with a beam axis (48) aligned along a standard direction successively onto processing locations (44) at which the temperature-controlling hollow structure (22) is to be produced. As a result, the substrate material is modified or removed at the processing locations (44). If an inclusion (52) is on the beam axis (48) aligned along the standard direction, the direction of the beam axis (48) relative to the mirror substrate (12) is changed such that the beam axis (48) does not intersect the inclusion (50). Any residues (74) can be removed by inserting a lance (76) into the cooling channel in order to break off the residues.

## Description

### BACKGROUND OF THE INVENTION

### 1. Field of the invention

The invention relates to a method for generating a temperature-controlling hollow structure in a substrate using a processing light beam. The substrate may be in particular a mirror substrate for a mirror of an EUV projection exposure apparatus or another semiconductor technology apparatus.

### 2. Description of the prior art

Microlithographic projection exposure apparatuses are used in chipmaking in order to transfer structures on a mask to a photoresist that has been applied to a wafer beforehand. For this purpose, the mask is illuminated with light and imaged onto the light-sensitive layer in a reduced size. In EUV projection exposure apparatuses, the light has a wavelength of between approximately 5 nm and approximately 30 nm; the apparatuses that are commercially available use light with a wavelength of 13.5 nm.

However, there are no optical materials which have a sufficiently high transmissivity for such short wavelengths. Therefore, in EUV projection exposure apparatuses, the lens elements that have been customary at longer wavelengths are replaced by mirrors and therefore the mask also contains a pattern of reflective structures.

The provision of mirrors for EUV projection exposure apparatuses is technologically demanding. The mirror substrate consists of a substrate material which is generally glass, e.g. titanium-doped quartz glass such as ULE^{®}, or a glass ceramic. A coating which reflects the EUV light and consists of a multiplicity of thin double layers having alternating refractive indices is applied to the mirror substrate by vapor deposition.

Even with such complexly constructed coatings, however, the reflectivity of the mirrors for the EUV light is rarely more than 70%, and even this is only for light which impinges on the reflective coating with normal incidence or with angles of incidence of a few degrees. That portion of the EUV light that is not reflected by the coating is absorbed in the mirror substrate, where it leads to considerable heating since the EUV light sources used are very powerful. Even if glass ceramics having low coefficients of thermal expansion are used, the heating may lead to unacceptable changes in shape of the mirrors.

The developers of other semiconductor technology apparatuses, e.g. mask or wafer inspection apparatuses, are also faced with the same problems, since these apparatuses also make use of mirrors that heat up under the influence of radiation.

It has therefore been proposed to provide the mirror substrate with cooling channels, through which water or another fluid flows during operation and in this way dissipates heat. The cooling channels have a cross section of the order of magnitude of around 1 mm² and ideally extend at a defined distance underneath the reflective coating.

The applicant's application DE 10 2021 214 310.5 gives an overview of the hitherto known methods for producing the cooling channels. Methods in which a processing light beam is successively focused onto processing locations where cooling channels are to be produced are particularly promising. This modifies the substrate material at the processing locations such that it can be removed by chemical processing in a subsequent step. As an alternative, the substrate material may also be removed directly by the processing light beam; resulting residues are then rinsed away by a rinsing liquid.

However, it has been found that the processing results are occasionally unsatisfactory, because the walls of the cooling channels are not formed smoothly, but irregularly.

Similar problems also occur in other contexts. In order to keep a substrate exactly at a determined temperature, a channel produced in the substrate can also be used for heating. The substrate also does not have to be part of a mirror, and instead may bear e.g. a sensitive sensor which must be at an exactly defined position. If the substrate is exposed to high thermal loading that varies over time, e.g. owing to fluctuating electrical power losses of adjacent components or only intermittently incident radiation, it is possible for changes in shape of the substrate and thus undesired changes in position of the sensor to occur. Hollow structures through which a cooling or heating fluid flows can also be used for such substrates to keep the substrate at a constant setpoint temperature.

In the following text, reference is therefore made in general to temperature-controlling hollow structures, even though frequently it is cooling channels that are involved.

The substrate does not need to be transparent to visible light. It is thus possible to produce hollow structures for example in silicon, which is not transparent to visible light, if the processing light beam has a wavelength of around 2 µm.

### SUMMARY OF THE INVENTION

An object of the invention is to specify a method for producing a temperature-controlling hollow structure in a substrate, in the case of which method the temperature-controlling hollow structure has a more uniform cross section than in the case of known methods.

### 1. Changes to the beam axis

This object is achieved by a method for producing a temperature-controlling hollow structure in a preferably monolithic substrate, in particular in a mirror substrate for a semiconductor technology apparatus, having the following steps:
a) providing the substrate, which consists of a substrate material;
b) measuring where inclusions are in the substrate;
c) working the temperature-controlling hollow structure into the substrate by focusing a processing light beam with a beam axis aligned along a standard direction successively onto processing locations at which the temperature-controlling hollow structure is to be produced, as a result of which the substrate is modified or removed at the processing locations;
wherein
in step c), at least if an inclusion measured in step b) is on the beam axis aligned along the standard direction, the direction of the beam axis relative to the substrate is changed such that the beam axis does not intersect the inclusion.

The invention is based on the finding that non-uniformly formed temperature-controlling hollow structures can be caused by gas bubbles and other inclusions in the mirror substrate. If the processing light beam is incident for example on a gas bubble on its way to the processing location, the gas bubble acts like a small lens element that deflects the incident processing light beam. The deflected light generally no longer reaches the processing location, which is why under certain circumstances the beam intensity necessary for the desired modification or the removal of the substrate material is no longer available there. If less material is modified or removed at the processing location as a result, this leads to undesired changes in cross section of the temperature-controlling hollow structure.

The worst case involves interruption of the process, because material can no longer be modified or removed at all.

The circumstances are similar in the case of inclusions, which absorb the processing light and in this way attenuate the intensity at the processing location.

According to the invention, this problem caused by the inclusions is solved by first of all measuring where the inclusions are in the substrate. If the locations of the inclusions are known, the positions in the process at which the beam axis of the processing light beam would intersect an inclusion can be calculated in advance. At the positions calculated in advance, the direction of the beam axis of the processing light beam is changed such that the beam axis cannot intersect the respective inclusion. This ensures that at most a relatively small part of the processing light beam is hindered in its propagation through the inclusion. The change in direction allows the processing light beam to propagate obliquely underneath the inclusion and thus reach regions in the substrate which would be shaded by the inclusion in the case of a processing light beam propagating in the standard direction.

When the positions at which the direction of the beam axis of the processing light beam is to be changed are calculated in advance, it is also possible to apply a stricter criterion than the presence of an intersection point between the beam axis and the inclusion. A change in direction of the beam axis can be performed, e.g., already when at least p% of the intensity of the processing light beam is exposed to the inclusion. In this case, the calculation is more complex because it is not only necessary to calculate the beam axis in the substrate, but also to take into account the usually Gaussian beam profile of the processing light beam at the level of the inclusion. The percentage p can be variable and depend, e.g., on the position of the inclusion relative to the processing location.

The temperature-controlling hollow structures are generally cooling channels, the cross section of which does not need to be constant and which may be e.g. circular, rectangular or annular. The temperature-controlling hollow structures may also be extensive chambers in which the temperature-controlling liquid is exchanged only slowly and in which no longitudinal axis is defined, as is characteristic of a channel.

The standard direction along which the processing light beam propagates normally, i.e. in the absence of inclusions, during the processing is generally established such that it extends at least substantially perpendicularly to a longitudinal axis of the temperature-controlling hollow structure. Primarily if the temperature-controlling hollow structure is curved or angled, or the temperature-controlling hollow structure is not a channel, the standard direction may also be defined differently. If e.g. a channel-like temperature-controlling hollow structure contains a portion at a 90° angle, the standard direction within this portion may also extend parallel to the longitudinal axis of the channel-like temperature-controlling hollow structure.

If initially the processing light beam propagates along the standard direction, and the direction of the beam axis is then changed in the event of an inclusion and reset back to the standard direction after the inclusion, this corresponds to changing the direction of the beam axis twice for each inclusion.

However, it is frequently not possible to process all the regions in the substrate that are shaded by the inclusion using only one direction that deviates from the standard direction. Primarily if the inclusion is very close to the processing location, it is necessary to change the direction of the beam axis more often, e.g. three times.

Normally, the temperature-controlling hollow structure is produced along a predefined process direction which, in the case of channels, extends parallel to the longitudinal axis of the channel. The processing locations can be reached by the processing light beam better if, a first time the direction of the beam axis is changed, it is changed by a first angle α1 with respect to the standard direction such that the processing light beam is directed underneath the inclusion as seen in the process direction. A second time the direction of the beam axis is changed, it is changed by a second angle α2 with respect to the standard direction such that the processing light beam is directed underneath the inclusion as seen counter to the process direction. Essentially, in the case of this procedure the processing light beam is thus directed obliquely underneath the inclusion on either side, in order to also be able to modify or remove substrate material there. In the event of a third time, either the beam axis is reset back to the standard direction or there follows a change in the beam direction by a third angle α3, which runs in a plane perpendicular to the process direction.

Ideally, the angles α1 and α2 are the same in absolute terms, corresponding to a symmetrical processing situation. If the processing situation is or is to be asymmetrical, angles α1 and α2 that are different in absolute terms can be selected.

It is possible to achieve even better reachability of regions that would be shaded by the inclusion in the case of a processing light beam propagating in the standard direction if, at least once when its beam axis is not aligned parallel to the standard direction, the processing light beam passes through a liquid or solid medium directly adjoining a portion of the surface of the substrate through which the processing light beam passes.

Without such a medium, the processing light beam is subject to light refraction at the interface between the substrate and the surrounding atmosphere, which is generally air. If a processing light beam is incident at an inclination, it is refracted toward the perpendicular, but this makes it harder to reach said regions. If water or a similar liquid adjoins the substrate, this refraction is reduced. If the solid medium has a higher refractive index than the substrate material, it is even possible to achieve refraction away from the perpendicular, this further improving the accessibility of said regions.

If the medium is liquid, said portion of the surface of the substrate may be inclined such that a horizontal surface, facing toward the surrounding atmosphere, of the liquid medium extends perpendicularly to the processing beam. If the liquid medium and the substrate have similar refractive indices, the beam axis of the processing light beam is not refracted at all when it enters the liquid medium and is refracted only slightly when it subsequently enters the substrate. Generally, such an arrangement requires the substrate as a whole to be tilted, with the result that the surface facing toward the processing light beam is inclined. The liquid medium may be retained by barriers, which are temporarily fastened to the surface and form a trough for the liquid medium.

Even if the medium is solid and has a higher refractive index than the substrate, a surface facing away from the substrate should extend perpendicularly to the processing beam, in order to prevent a change in direction of the beam axis there. The medium then preferably has the form of a wedge or truncated wedge.

In one exemplary embodiment, the processing light beam has a rotationally asymmetrical beam profile when it enters the substrate. The longest diameter of the beam profile is at least twice the shortest diameter of the beam profile. Before and after its direction is changed, the beam axis lies in a plane in which the beam profile has its shortest diameter.

Such a beam profile is advantageous because the processing light beam is thus particularly narrow in the process direction and as a result, after the change in direction in the processing process, is incident on the inclusion later than a conventional processing light beam with a rotationally symmetrical beam profile is. As a result, it is also possible using such a beam to process regions which cannot be reached by a conventional processing light beam owing to the shading by the inclusion.

In order to generate such a beam profile, the processing light beam may pass through a beam-profile changing device, which correspondingly changes the beam profile, before it enters the substrate. In the simplest case, such a beam-profile changing device contains at least one cylindrical lens element or another anamorphic optical element with a similar effect. As an alternative, diffractive optical elements (DOEs) or spatial light modulators can be used to change the beam profile.

### 2. Removal of residues

The method according to the invention makes it possible to produce temperature-controlling hollow structures which, in comparison with the temperature-controlling hollow structures producible hitherto, have considerably more uniform cross sections and smoother inner surfaces. In many cases, however, in spite of the measures according to the invention, residues of substrate material remain in the temperature-controlling hollow structures and protrude from the inner surface into the temperature-controlling hollow structure like stalactites on a cave wall. If such residues exceed a certain size, adverse effects on the function cannot be ruled out. In the limiting case, the residues are so large that the temperature-controlling hollow structure is completely closed by a structure which, although it is thin, is impermeable to the cooling or heating fluid flowing through.

According to the invention, the remaining residues in the temperature-controlling hollow structure are mechanically broken up. This either directly largely destroys the residues or damages them such that they can be removed in the same or in a further processing step. The material removal operation can also be done mechanically, e.g. using a rinsing liquid or using an element that carries the rinsing liquid. As an alternative, it is possible to use a fluid which chemically dissolves the broken-up residues and carries them along with it.

The mechanical breaking up can be brought about e.g. using a pressurized fluid, which is introduced into an already present temperature-controlling hollow structure just in the course of being created.

With preference, for the breaking-up operation, a lance is inserted into an already produced temperature-controlling hollow structure or, while a temperature-controlling hollow structure is being produced, into the substrate. If a free end of the lance strikes a disruptive residue as it is being inserted, the residue is broken off and possibly comminuted by the impulse of the moving lance. This makes it possible to break up even complete closures of the temperature-controlling hollow structures. The tiltings according to the invention of the beam direction ensure that such closures are so thin that they can be broken up by the lance. Simulations have shown that the force typically required to break off a residue is of the order of magnitude of 0.1 N.

The residues then still remaining form elevations, which have a maximum height h, where 15 µm < h < 50 µm, with respect to the surrounding and otherwise smooth inner surface. In relation to typical widths of temperature-controlling channels of approximately 2 mm, this is a very low value, and therefore the flow of the fluid through the elevations is at most slightly disrupted. In this context, smooth is understood to mean an inner surface which has a maximum roughness depth Rt of less than 5.0 µm and preferably less than 3.0 µm.

In a subsequent (possibly second) treatment step with a chemically active and preferably liquid medium, the remaining comminuted residues can be subjected to further material removal and rounding. This makes it possible to reduce the maximum height h of the elevations to values of 15 < h < 25 µm. Such flat elevations generally do not lead to any adverse effects on the function upon later use of the substrate.

The lance may be a dedicated tool, which is in the form e.g. of a thin but sufficiently stiff wire and only serves to destroy the residues. If the temperature-controlling hollow structure is a channel with a uniform diameter and slight curvatures, it is possible to use a lance which has a diameter adapted to the diameter of the channel, i.e. has the same shape but somewhat smaller dimensions. This makes it possible to break off the residues such that only very short stumps are left.

The lance used may alternatively also be a (possibly guidable) flexible tube, which is inserted by hand or using a tracking unit into the already produced temperature-controlling hollow structure or, while a temperature-controlling hollow structure is being produced, into the substrate, in order to discharge a chemical rinsing or processing liquid. A rinsing liquid is preferably used if the processing light beam has removed the substrate material. If the substrate material is only slightly modified by the processing beam, a subsequent chemical processing step with a chemical processing liquid, such as e.g. an etching liquid or another chemically active medium, is necessary. The stiffness of the flexible tube can be established by, among other things, the material selection, the flexible-tube diameter, the wall thickness of the flexible tube and the pressure of the chemical processing liquid in the flexible tube.

If the lance is a flexible tube, the impulse can also be transferred to residues indirectly via a rinsing fluid. In this case, the rinsing fluid exits the flexible tube at a sufficiently high pressure and tears the residues away from the inner surface of the temperature-controlling hollow structure. Direct contact of the flexible tube with the residues is not necessary in this case. Since the flexible tube does not need to make direct contact with the residues, it can be relatively soft, and this makes it easier to navigate it in the temperature-controlling hollow structure.

A suitable rinsing fluid is, in particular, water or another liquid, on account of the relatively large mass. In principle, however, air or another gas (mixture) can also be considered.

The fluid preferably exits the flexible tube in pulses. The pressure surges generated in this way enhance the transfer of impulse to the residues, as a result of which they break off more quickly and more reliably.

Irrespective of the type of lance, it is advantageous to move it alternately back and forth while the residues are being removed. In this way, the lance or a fluid exiting it can strike a residue repeatedly and gradually remove more and more of its material.

The mechanical breaking up operation can be carried out after the temperature-controlling hollow structure has been produced. In the case of some processing methods, there is the option of mechanically breaking up the residues already while the temperature-controlling hollow structure is being produced. Such processing methods are described in the patent application with the title "Verfahren zur Einarbeitung von Kühlhohlstrukturen in ein Spiegelsubstrat eines Spiegels für eine EUV-Projektionsbelichtungsanlage sowie Bearbeitungssystem hierfür" ["Method for working cooling hollow structures into a mirror substrate of a mirror for an EUV projection exposure apparatus, and processing system therefor", which was filed by the applicant at the German Patent and Trademark Office on the same day. In the case of this processing method, a flexible tube is inserted into the substrate while the processing light beam removes or modifies the substrate material. This flexible tube can be used as a lance in the way set out above and mechanically break up the just recently produced residues either by way of its movement or by ejection of a fluid.

A lance for breaking up residues can also be used if there are residues remaining in the temperature-controlling hollow structure that are not caused by inclusions. Therefore, another subject of the invention is a method for producing a temperature-controlling hollow structure in a substrate, in particular in a mirror substrate for a mirror of a semiconductor technology apparatus, having the following steps:
a) providing the substrate, which consists of a substrate material;
b) working the temperature-controlling hollow structure into the substrate by focusing a processing light beam with a beam axis aligned along a standard direction successively onto processing locations at which the temperature-controlling hollow structure is to be produced, as a result of which the substrate material is modified or removed at the processing locations;
c) inserting a lance into an already produced temperature-controlling hollow structure or, while a temperature-controlling hollow structure is being produced, into the substrate, as a result of which residues in the temperature-controlling hollow structure are broken up.

The combination of the (possibly repeated) tilting, set out above, of the beam axis of the processing light beam with the use of a lance for breaking off remaining residues has the effect that, in substrates with bubbles or other inclusions, the inner surfaces of the temperature-controlling hollow structures are so smooth that disruptive elevations, which do not contribute to the function of the temperature-controlling hollow structure but were caused by inclusions during the production of the temperature-controlling hollow structures, have a height of between 15 µm and 50 µm. The maximum height can be reduced to 25 µm if, after the lance has been inserted, the temperature-controlling hollow structure is rinsed and/or chemically processed with an etching liquid or with another chemically active medium, e.g. an oxidation or reduction agent.

When producing very small temperature-controlling hollow structures in highly pure glasses, it may be the case that, fortuitously, no inclusion hinders the processing light beam. However, the greater the extent of the temperature-controlling hollow structures, the more likely it is that inclusions form a hinderance. Indeed, the only things that are potentially disruptive in this case are those inclusions that are between the surface of the substrate that the processing light beam penetrates and the temperature-controlling hollow structure. The distance between the temperature-controlling hollow structure and this surface is frequently between 20 mm and 30 mm.

Glasses of the highest purity grade 0 have, for example, the property that, over a volume of 100 cm³, a total bubble cross-sectional area of 0.03 mm² is permissible, with the maximum allowed bubble diameter being 100 µm. In the case of typical channel widths of 2 mm and a total channel length of 50 cm, statistically there is exactly one bubble with a maximum diameter of 100 µm that hinders the processing light beam. The production of a channel hollow structure 10 mm wide and 10 cm long is statistically likewise disrupted by exactly one bubble.

If the substrate is a mirror substrate for a mirror of an EUV projection exposure apparatus or another semiconductor technology apparatus, the method can comprise the step of applying a multilayered coating to the substrate, this coating being designed to reflect at least 50% of incident EUV light.

Therefore, another subject of the invention is a mirror which comprises a substrate according to the invention and a coating borne by a support surface of the substrate. If the mirror is a mirror of an EUV projection exposure apparatus or another semiconductor technology apparatus, the coating should have the property of reflecting at least 50% EUV light, specifically in particular light having a wavelength of 13.5 nm.

While, as mentioned above, the distance between the temperature-controlling hollow structure and the surface onto which the processing light beam has been directed is often 20 mm to 30 mm, the distance between the temperature-controlling hollow structure and the support surface after the shaping processing of the mirror substrate by material removal is often only a few millimeters. In particular, the temperature-controlling hollow structure may extend at a distance from 1.0 mm to 50.0 mm, from 1.0 mm to 20.0 mm, from 1.0 mm to 10.0 mm or from 1.0 mm to 5.0 mm from the support surface. The inclusion may be in this interspace.

Owing to the material removal for the purposes of shaping, however, it is possible that an inclusion that has hindered the propagation of the processing light beam is no longer present in the resulting mirror. As a result, elevations may remain in the temperature-controlling hollow structures without the causes of this being discernible on the finished mirror. Therefore, another subject of the invention is a mirror having a temperature-controlling hollow structure which has a flat inner surface. The substrate consists of glass or a glass ceramic. The inner surface has a locally delimited elevation which does not contribute to the function of the temperature-controlling hollow structure and has a height h of between 15 µm and 50 µm. The temperature-controlling hollow structure extends at a distance from 1.0 mm to 50.0 mm, from 1.0 mm to 20.0 mm, from 1.0 mm to 10.0 mm or from 1.0 mm to 5.0 mm from the support surface.

Another subject of the invention is a semiconductor technology apparatus which contains a mirror according to the invention, a substrate according to the invention and/or a substrate produced by the method according to the invention. The apparatus may be e.g. a projection exposure apparatus, a mask inspection apparatus or a wafer inspection apparatus. Semiconductor technology apparatuses contain substrates or mirrors for which temperature control using temperature-controlling hollow structures is advantageous in many cases. In addition to the substrates and mirrors, such apparatuses typically contain a light source, which may be designed for example to generate EUV radiation, and mechanical components, which can be used to align and/or move masks (also referred to as reticles), wafers or sensors.

### 3. Changes in the beam profile

In addition or as an alternative to the change in the beam axis set out above, it is possible to change the beam profile of the processing light beam. A corresponding method for producing a temperature-controlling hollow structure in a substrate comprises the following steps:
a) providing a substrate, which consists of a substrate material;
b) working temperature-controlling hollow structures into the substrate by focusing a processing light beam successively onto processing locations at which temperature-controlling hollow structures are to be produced, as a result of which the substrate material is modified or removed at the processing locations, the processing light beam passing through a beam-profile changing device, which redistributes radiation energy in the processing light beam in a radial direction, on its way to the substrate.

The inventors have found that temperature-controlling hollow structures with more uniform cross sections can be produced if the beam profile of the processing light beam is changed on its way to the substrate. The processing light beam is usually generated by a laser, and therefore the processing light beam initially, i.e. before entering the beam-profile changing device, has a Gaussian beam profile. In the case of such a beam profile, the majority of the radiation energy is concentrated onto a relatively small region around the beam axis; the intensity then slowly drops toward the outside. For the desired modifications in the substrate material, however, such a Gaussian beam profile is disadvantageous, because local and temporal fluctuations of the processing threshold - which is to say the intensity above which the desired material modifications occur - has a strong effect on the width of the material region modified by the processing light beam. A temperature-controlling hollow structure that has been produced with such a processing light beam therefore often has an irregular cross section, this being disadvantageous when a temperature-controlling fluid flows through it later on.

More uniform cross sections of the temperature-controlling hollow structures can be produced if the beam-profile changing device converts the initially Gaussian beam profile into a top hat beam profile. In the case of a top hat beam profile, the radiation energy is concentrated uniformly in a wider region around the beam axis, but then drops more abruptly toward the outside. Owing to the more abrupt drop, local and temporal fluctuations of the processing threshold have less of an effect on the size of the material region modified by the processing light beam.

As an alternative, the beam-profile changing device can convert the Gaussian beam profile into a donut beam profile. In the case of such a beam profile, the intensity maximum is outside the beam axis, and this leads to an approximately annular intensity distribution in the beam cross section. Since the intensity also drops quickly at the outer beam periphery in the case of a donut beam profile, the advantage of the more uniform cross sections of the temperature-controlling hollow structure remains. The low intensity on the beam axis, however, has the advantage that inclusions of gas bubbles or other impurities that are on the beam axis lead to a lower degree of shading and thus adversely affect the processing result to a lesser extent. The processing light beam runs to a certain extent around the outside of the inclusion and converges downstream of the inclusion, so that the substrate material is uniformly modified there.

If the processing light beam is not generated by a laser or the beam profile of the processing light beam is not Gaussian for other reasons, e.g. because the laser, in a luminophore, excites the emission of secondary radiation with a non-Gaussian distribution, the beam-profile changing device may also convert such different beam profiles into a top hat or a donut beam profile.

Possible beam-profile changing devices that can be used are e.g. diffractive optical elements (DOEs), which make it possible to selectively change the angular distribution of the incident processing light. A top hat, donut, or other desired spatial intensity distribution is then produced in the far field or downstream of a Fourier optical unit.

The beam-profile changing device preferably establishes the type and extent of the radial redistribution of the radiation energy variably depending on the processing situation. This makes it possible to generate the optimum beam profile for any processing situation.

If the substrate has, for example, numerous relatively large gas bubbles or other inclusions, it is possible to measure before step b) where the inclusions are in the substrate material. If an inclusion is on a beam axis of the processing light beam directed onto a processing location, the beam profile is converted into a donut beam profile beforehand. If there is no inclusion on the beam axis of the processing light beam directed onto the processing location, the beam profile can be converted into a top hat beam profile or another beam profile which leads to particularly good processing results.

The beam-profile changing device must in that case be capable of generating different beam profiles as required. For this, it can have e.g. an exchange holder for multiple diffractive optical elements, which make it possible to generate different beam profiles.

It is possible to continuously change the beam profile generated if the beam-profile changing device has a pair of complementary axicon elements, the distance between which can be changed. Such a pair of complementary axicon elements generates a donut beam profile, in the case of which the diameter of the light-free region continuously increases as the distance between the axicon elements increases.

In many cases, it is most advantageous if the beam-profile changing device converts a Gaussian beam profile selectively into a top hat beam profile or into a donut beam profile. The processing light beams generated by conventional laser light sources have a Gaussian beam profile; a top hat beam profile is frequently preferred if no gas bubbles or other inclusions hinder the processing light beam. If this is the case, the beam profile temporarily changes over from a top hat beam profile to a donut beam profile in order that the processing light beam can circumvent the inclusion.

Such a flexible and quick changeover between different types of beam profiles is not possible with exchangeable DOEs or with axicon elements. However, beam-profile changing devices having a spatial light modulator, as known from Kuang, Zheng et al. "Ultrafast laser beam shaping for material processing at imaging plane by geometric masks using a spatial light modulator", Optics and Lasers in Engineering 70 (2015): 1-5*,* are suitable.

In particular, the spatial light modulator used can be an array of tiltable micromirrors. The type and extent of the radial redistribution of the radiation energy can in that case be established by changing the tilt angle of the micromirrors. Such a micromirror array changes the angular distribution in a similar way to a DOE, but offers the option of changing the angular distribution within wider limits flexibly and very quickly (typically within a few microseconds).

### BRIEF DESCRIPTION OF THE DRAWINGS

Exemplary embodiments of the invention will be explained in more detail below on the basis of the drawings, in which:
- figure 1: shows a schematic cross section through a mirror for an EUV projection exposure apparatus;
- figure 2: shows a mirror substrate, into which cooling channels are inscribed using a processing light beam;
- figure 3: shows an enlarged detail of the mirror substrate shown in figure 2, in which mirror substrate there is a gas bubble;
- figure 4: shows a detail corresponding to figure 3, the processing light beam being largely blocked by the gas bubble;
- figures 5a to 5d: show multiple phases of a processing process, during which process the direction of the beam axis of the processing light beam is repeatedly changed;
- figures 6a to 6d: show illustrations corresponding to figures 5a to 5d, the processing light beam during some processing steps passing through a water bath produced on the surface of the mirror substrate;
- figures 7a to 7e: show illustrations corresponding to figures 5a to 5d for explaining a variant in which the processing light beam during some processing steps passes through a diamond wedge resting on the surface of the mirror substrate;
- figure 8: shows a schematic illustration corresponding to figure 2 according to another exemplary embodiment, in which a rotationally asymmetrical beam profile of the processing light beam is generated;
- figures 9a and 9b: show the rotationally asymmetrical beam profile of the processing light beam in two perpendicular sectional planes; and
- figure 10: shows an illustration corresponding to figure 5a with a processing light beam which has a rotationally asymmetrical beam profile;
- figure 11a to 11d: show multiple phases of a processing process, during which process residues in a cooling channel that was produced beforehand are broken off by a lance inserted in the cooling channel;
- figure 12: shows a variant in which the residue is broken off not directly by the lance but indirectly via an outflowing fluid;
- figure 13: shows a cooling channel with an elevation that remains after the residue is broken off;
- figure 14: shows the cooling channel according to figure 13 after an additional chemical processing step;
- figure 15: shows a processing process with a processing light beam, in the case of which process the mirror substrate is covered by a liquid layer;
- figure 16: shows the processing process according to figure 15, in the case of which process the liquid has a lower refractive index than the mirror substrate;
- figure 17: shows the processing process according to figure 15, in the case of which the liquid has a higher refractive index than the mirror substrate;
- figure 18: shows the processing process according to figure 15, during which the temperature of the liquid is controlled and the liquid is circulated;
- figure 19: shows a processing process during which multiple processing light beams are directed onto the mirror substrate at the same time from different directions;
- figure 20: shows a processing process during which the processing light beam is guided over the mirror substrate using a polygon scanner and a z shifter;
- figure 21: shows a Gaussian beam profile, as generated by a laser light source;
- figure 22: shows a top hat beam profile, as can be generated by a beam-profile changing unit;
- figure 23: shows a donut beam profile, as can likewise be generated by the beam-profile changing unit;
- figure 24: shows a detail of the mirror substrate and a processing light beam which penetrates it and has a Gaussian beam profile;
- figure 25: shows the detail of figure 24, but the processing light beam has a donut beam profile;
- figures 26a to 26c: show the effect of a pair of axicon elements on the processing light beam with various axial distances between the axicon elements;
- figure 27: shows a beam-profile changing unit with a micromirror array, which makes it possible to establish just about any desired beam profile;
- figure 28: shows a measuring structure for locating gas bubbles in mirror substrates, in the case of which ultra-short light pulses pass through the mirror substrate;
- figure 29: shows a measuring structure for locating gas bubbles in mirror substrates, in the case of which scattered light emitted by gas bubbles is detected by incoherent lensless imaging; and
- figure 30: shows a variant of the measuring structure shown in figure 29, in the case of which the mirror substrate is incoherently illuminated from different directions;
- figure 31: shows an arrangement of measuring cameras relative to a mirror substrate for process monitoring purposes; and
- figure 32: shows a schematic illustration of a microlithographic EUV projection exposure apparatus.

### DESCRIPTION OF PREFERRED EXEMPLARY EMBODIMENTS

### 1. Structure of an EUV mirror

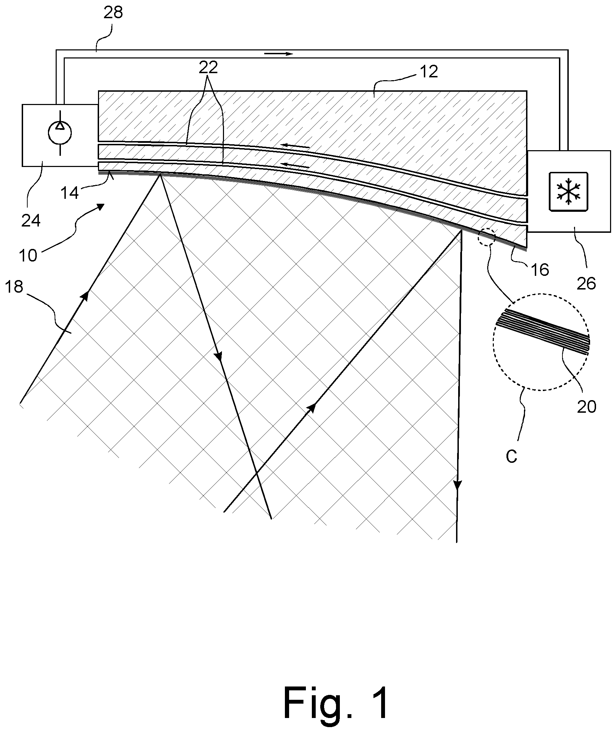

Figure 1 shows a schematic cross section of a mirror, denoted overall by 10, for an EUV projection exposure apparatus or another semiconductor technology apparatus. There, the mirror 10 can be arranged in the illumination system or in the projection lens.

The mirror 10 comprises a mirror substrate 12, which consists of a glass ceramic in the exemplary embodiment illustrated. Suitable glass ceramics are provided under the trade names Clearceram^{®} or Zerodur^{®} and have the property of having a very low coefficient of thermal expansion at the operating temperature of the mirror 10. The mirror substrate 12 is monolithic, i.e. it consists of a single continuous piece of material that was not obtained by joining individual pieces together.

The mirror substrate 12 has a precisely processed support surface 14, the curvature of which determines the optical properties of the mirror 10. The support surface 14 of the mirror substrate 12 bears a coating 16, which largely reflects incident EUV light 18. As can be seen in the enlarged detail C, the coating 16 consists of multiple double layers 20 that have been applied to the support surface 14. The coating 16 may have a reflection coefficient of more than 70% for normal-incidence EUV light 18.

The non-reflected portion of the UV light 18 penetrates the mirror substrate 12 and is absorbed there, specifically predominantly in the vicinity of the support surface 14. Owing to this absorption, the mirror substrate 12 heats up primarily in the vicinity of the regions of the support surface 14 which are exposed to the EUV light 18. Since the coefficient of thermal expansion of the substrate material is not equal to zero and in addition is itself temperature-dependent, the heating up can give rise to changes in shape of the mirror substrate 12 which affect the optical properties of the mirror 10. On account of the extremely tight specifications in semiconductor technology apparatuses, however, changes in the optical properties of the mirrors are unacceptable or acceptable at most to a negligible extent.

In order to minimize temperature fluctuations and associated changes in shape of the mirror substrate 12, multiple cooling channels 22 are worked in the mirror substrate 12. The cooling channels 22 typically extend in the vicinity of and parallel to the support surface 14. The arrangement of the cooling channels 22 that is illustrated in figure 1, however, is only by way of example and can be different in real systems. It is thus possible, for example, to provide only a single cooling channel 22 which winds its way through the mirror substrate 12 or part thereof.

During operation of the semiconductor technology apparatus, water or another cooling liquid flows through the cooling channels 22. The water absorbs the quantity of heat input by the EUV light 18 and dissipates it from the mirror substrate 12. To this end, the cooling channels 22 are connected to a pump unit 24 and a cooling unit 26. The pump unit 24 draws in the water from the cooling channels 22 and feeds it to the cooling unit 26 via a return line 28. There, the water is cooled down to its setpoint temperature before it flows through the cooling channels 22 again.

### 2. Producing the cooling channels

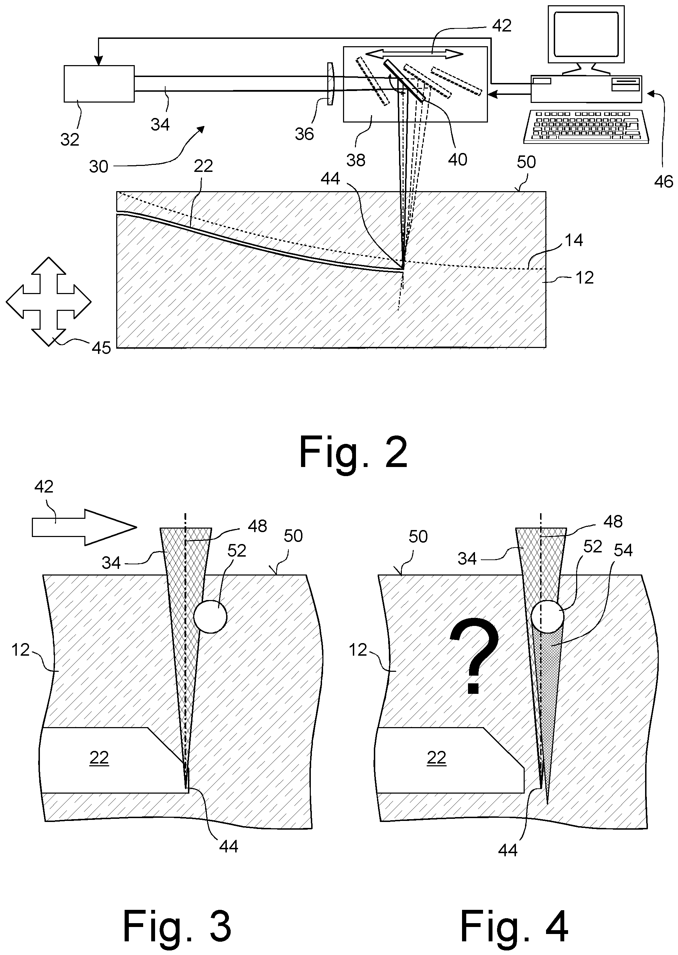

Figure 2 shows the mirror substrate 12 in a different orientation before the production of the support surface 14, depicted as a dashed line, by material removal. A processing device 30, which can be used to inscribe the cooling channels 22 into the mirror substrate, is schematically illustrated above the different orientation of the mirror substrate 12. The processing device 30 has a light source 32, which generates a processing light beam 34. The light source 32 is preferably a powerful laser that generates ultrashort pulses. The processing light beam 34 passes through a focusing lens 36 and can then be directed onto the mirror substrate 12 at different angles using an adjustment device 38. To this end, in the exemplary embodiment illustrated the adjustment device 38 comprises a tiltable mirror 40, which additionally is linearly displaceable parallel to the process direction, indicated by 42. The process direction 42 extends in the longitudinal direction of the cooling channel 22 and thus corresponds to the direction along which the modification or material removal process proceeds.

If the mirror 40 is both tilted and linearly displaced, it is possible to change the direction of the beam axis of the processing light beam 34 without appreciably changing the location of the focus 44. Figure 2 uses dashed lines to indicate by way of example various tilting and displacement positions of the mirror 40, in the case of which positions only the direction of the beam axis changes; the focus 44 remains approximately the same. In order that the focus 44 remains at exactly the same location, it is additionally necessary to displace the focusing lens element 36 along the optical axis.

In order to be able to carry out material processing at all the desired locations in the mirror substrate 12, the relative arrangement between the mirror substrate 12 and the processing device 30 must be changeable. For this, for example, the mirror substrate 12 can be linearly displaced in all three spatial directions using a displacement stage, which is not illustrated, as indicated by a multi-headed arrow 45. It is frequently advantageous if the mirror substrate 12 not only is linearly displaceable but also can be tilted about at least one axis.

The displacement stage and the adjustment device 38 are then controlled by a control device 46 such that the processing light beam 34 is focused successively onto all the processing locations at which cooling channels 22 are to be produced.

As an alternative to this, the relative arrangement between the mirror substrate 12 and the processing device 30 can of course also be changed by moving the processing device 30.

At the focus 44 generated by the focusing lens 36, the intensity of the processing light beam 34 is so high that irreversible modifications of the substrate material occur. Depending on the procedure, substrate material can be removed such that it can be rinsed away in a subsequent process step. However, modifications of the substrate material which merely have the effect of being able to selectively dissolve away the mirror substrate 12 in a subsequent chemical processing step also come into consideration. In both cases, the location of the focus 44 determines where a cooling channel 22 is produced in the mirror substrate 12.

In order to produce a cooling channel 22 with a sufficiently large cross section, the processing light beam 34 travels over the entire cross section according to a predefined pattern, starting from a determined axial position. Then, this process is repeated at respective adjacent axial positions until the cooling channel 22 has the desired axial dimension.

### 3. Circumvention of gas bubbles and other inclusions - first exemplary embodiment

Figure 3 shows an enlarged detail from figure 2, while the processing light beam 34 is producing the cooling channel 22. The processing light beam 34 has a beam axis 48, which in the present case is understood to mean the energetic center axis of the processing light beam 34. In the case of processing light beams 34 having a rotationally symmetrical beam profile, as are typically generated by the lasers used as light source 32, the beam axis 48 generally coincides with the axis of symmetry.

In the case of the constellation illustrated in figure 3, that surface 50 of the mirror substrate 12 that faces the processing device 30 extends parallel to the process direction 42. In order to reduce scattering losses at the surface 50, it can be polished before the processing. The beam axis 48 of the processing light beam 34 is aligned perpendicularly to the surface 50 and thus also perpendicularly to the process direction 42. The processing light beam 34 therefore penetrates the mirror substrate 12 with normal incidence, so that the beam axis 48 is not deflected owing to refraction at the surface 50, which forms the interface between the mirror substrate 12 and the surrounding atmosphere (generally air).

The direction perpendicular to the surface 50 is referred to below as standard direction, because it is preferred if the cooling channels 22 are produced with a processing light beam 34 aligned in this way, subject to the exceptions discussed below.

Figure 3 shows a spherical gas bubble 52 which is created during the production of the mirror substrate 12. If processing light is incident on the gas bubble 52, it is refracted at the interface of the gas bubble 52 and generally deflected such that it no longer reaches the focus 44. The processing light incident on the gas bubble 52 is thus lost to the processing.

In the constellation shown in figure 3, only a relatively small part of the processing light beam 34 is incident on the gas bubble 52. If the processing light beam 34 has a Gaussian beam profile, the intensity decreases considerably as the distance from the beam axis 48 increases, with the result that material processing is still possible even in the constellation shown in figure 3. However, the greater the proportion of the processing light that is incident on the gas bubble 52 is, the less light is available at the focus 44 for material processing.

In the constellation shown in figure 4, the beam axis 48 intersects the gas bubble 52, so that a considerable part of the processing light, specifically in particular the generally high-energy center of the processing light beam 34, does not reach the focus 44 and thus cannot contribute to material processing. As indicated by a dark hatched region in figure 4, the gas bubble 52 results in a shaded area 54 in the case of a processing light beam 34 which is incident on the mirror substrate 12 parallel to the standard direction. The processing light beam 34 cannot process the substrate material in the region of the shaded area 54, and therefore it is also not possible to produce a cooling channel 22 there. Such a process interruption is to be avoided.

According to the invention, therefore, a measurement is taken even before the cooling channels 22 are worked in as to where gas bubbles 52 and similar inclusions are in the mirror substrate 12. In order to measure the locations of the gas bubbles 52, white light can be shone through a small region of the mirror substrate 12, e.g. from one side. A camera records an image of the region on the opposite side. The position and size of the gas bubbles can then be calculated on the basis of the light scattering shown in the image. In this way, the entire mirror substrate can be surveyed in succession. Alternative methods for locating the gas bubbles 52 are explained later on in section 11.

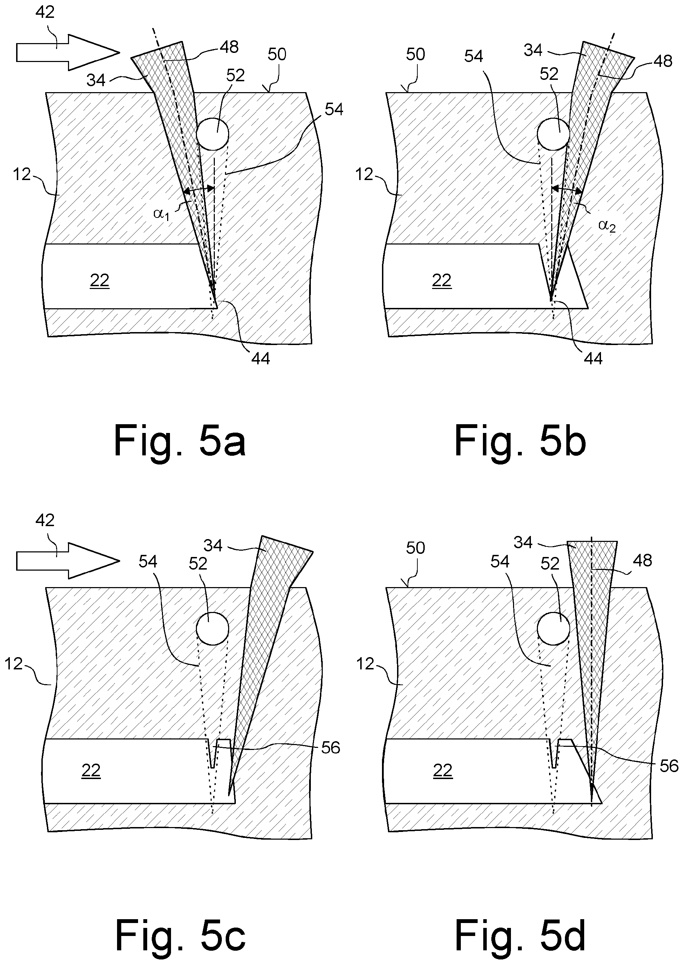

In order to not arrive at the undesired constellation shown in figure 4, if a gas bubble 52 is on the beam axis 48 aligned along the standard direction, the direction of the beam axis 48 relative to the mirror substrate 12 is changed such that the beam axis 48 does not intersect the gas bubble 52, as illustrated in figure 5a. This is achieved by directing the processing light beam 34 onto the surface 50 of the mirror substrate 12 at a different angle using the adjustment device 38. The processing light beam 34 is then refracted at the surface 50 of the mirror substrate 12, with the result that, in the mirror substrate, the beam axis 48 no longer extends parallel to the standard direction, but at an angle α₁ to it. If the "direction of the beam axis 48" is mentioned below, it always means the beam axis 48 inside the mirror substrate 12, i.e. after refraction at the surface 50.

Since the air surrounding the mirror substrate 12 has a lower refractive index than the substrate material, the processing light beam 34 is refracted toward the perpendicular, as shown in figure 5a. Owing to the inclined beam axis 48, the processing light beam 34 reaches regions of the mirror substrate 12 that lie at the lower end of the shaded area 54, indicated in dashed line. The processing light beam 34 shaded by the gas bubble 52 can thus process the substrate material in these regions in the desired way. It is clear from figure 5a that the processible region is all the larger the greater the distance between the gas bubble 52 and the cooling channel 22 is. If the gas bubble 52 is directly above the cooling channel 22, the processible region that lies within the shaded area 54 is very small.

If the constellation shown in figure 5a is reached, the processing is interrupted by turning off or stopping down the light source 32. Then, the direction of the processing light beam 34 is changed a second time, in order to obtain the constellation shown in figure 5b. The beam axis 48 then runs at an angle α₂ = - α₁ to the standard direction. While in figure 5a the processing light beam 34 is directed underneath the gas bubble 52 as seen in the process direction 42, in figure 5b the processing light beam 34 passes underneath the gas bubble 52 as seen counter to the process direction 42. In this way, it is possible to process further regions that lie in the region of the shaded area 54. The angles α₁ and α₂ formed by the beam axis 48 in relation to the normal-incidence standard direction upstream and downstream of the gas bubble 52 have a magnitude of approximately 13° in the exemplary embodiment illustrated. The larger these angles are, the larger too is the region which can be reached by the processing light beam 34 within the shaded area. However, the sizes of the angles α₁, α₂ are subject to limits, because the processing light beam 34 is increasingly polarized as the angles of incidence α₁, α₂ converge on Brewster's angle. Moreover, large angles of incidence α₁, α₂ lead to an undesired lengthening of the pulse duration and a distortion of the beam profile, since the distance to the processing location is significantly shorter for the flanks of the processing light beam 34 that are inclined toward the surface than for the other flanks.

The processing with the oblique position, shown in figure 5b, of the beam axis 48 can still be continued for a certain period of time, until the gas bubble 52 is far enough away; cf. figure 5c. Then, the direction of the beam axis 48 is changed a third time, by returning it back to the standard direction. For this, the processing light beam 34 is made to impinge on the surface 50 with normal incidence again using the adjustment device 38. This state is shown in figure 5d.

Figures 5c and 5d show that it was not possible for the processing light beam 34 to reach a small region 56 within the shaded area 54. The region 56 is so small, however, that although the cooling channel there experiences a cross-sectional narrowing, it still remains permeable to the later cooling liquid. If the gas bubble 52 is further away from the cooling channel 22 and/or the angles α₁, α₂ are enlarged in absolute terms, the size of the unprocessed region 56 can be decreased.

### 4. Further exemplary embodiments

The following text describes variants which make it possible to further decrease the size of the remaining unprocessed regions 56.

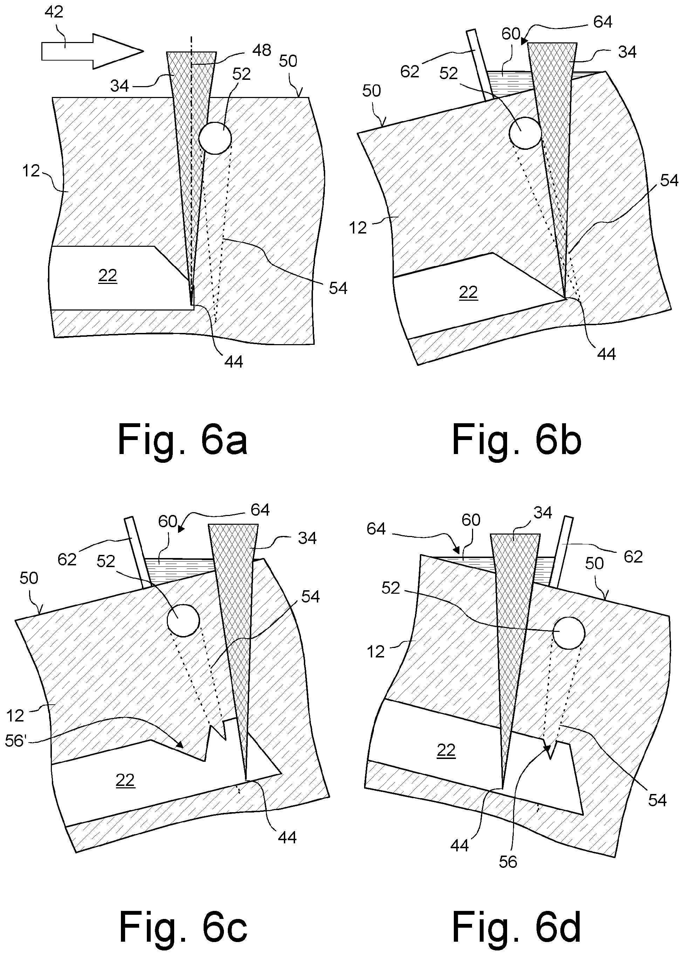

Figure 6a again illustrates (similar to figure 3) the constellation when the processing light beam 34, aligned along the standard direction, is incident on the gas bubble 52 and therefore the direction of the beam axis 48 needs to be changed.

As shown in figure 6b, in this variant the direction of the beam axis 48 in the mirror substrate is not brought about by tilting the processing light beam 34, but by tilting the mirror substrate 12. This measure is necessary in order for the processing light beam 48 to be able to enter a water bath 60, which has been produced on the surface 50 of the mirror substrate 12, with normal incidence. To this end, barriers 62 are temporarily fastened on the surface 50, of which only the barrier 62 extending perpendicularly to the plane of the drawing is shown in figures 6b to 6d. Two barriers extending parallel to the plane of the drawing are not illustrated for the sake of clarity.

Together, the barriers 62 form a trough 64, and the water 60 it contains cannot flow out of it. The water 60 has a refractive index which is somewhat lower than that of the mirror substrate 12. As a result, the processing light beam 34 is only slightly refracted at the surface 50 of the mirror substrate. A comparison with figure 5b shows that this allows the processing light beam 34 to reach a larger region within the shaded area 54.

Figure 6c shows the processing at a later point in time, after the mirror substrate 12 has been moved counter to the process direction 42.

Then, the processing is continued on the opposite side of the gas bubble 52, as illustrated in figure 6d. For this, the mirror substrate 12 is tilted in the opposite direction and the trough 64 is relocated mirror-symmetrically. This allows the processing light beam 34 to process a region 56' which was not accessible for the processing light beam 34 during the processing phases shown in figures 6a and 6b. As shown in figure 6d, a small region 56 remains unprocessed in this variant, too, since it cannot be reached by the processing light beam 34 from any side.

The use of a liquid has the advantage that it is not necessary to polish the surface 50 as a result. Without polishing, the surface 50 would be so rough that the majority of the incident processing light beam 34 would be lost to the processing by scattering. Further explanations in this regard are given in section 7 later on.

In an alternative exemplary embodiment, the processing light beam does not pass through a liquid medium but a solid one, which directly adjoins the surface 50 of the mirror substrate in the portion through which the processing light beam 34 passes.

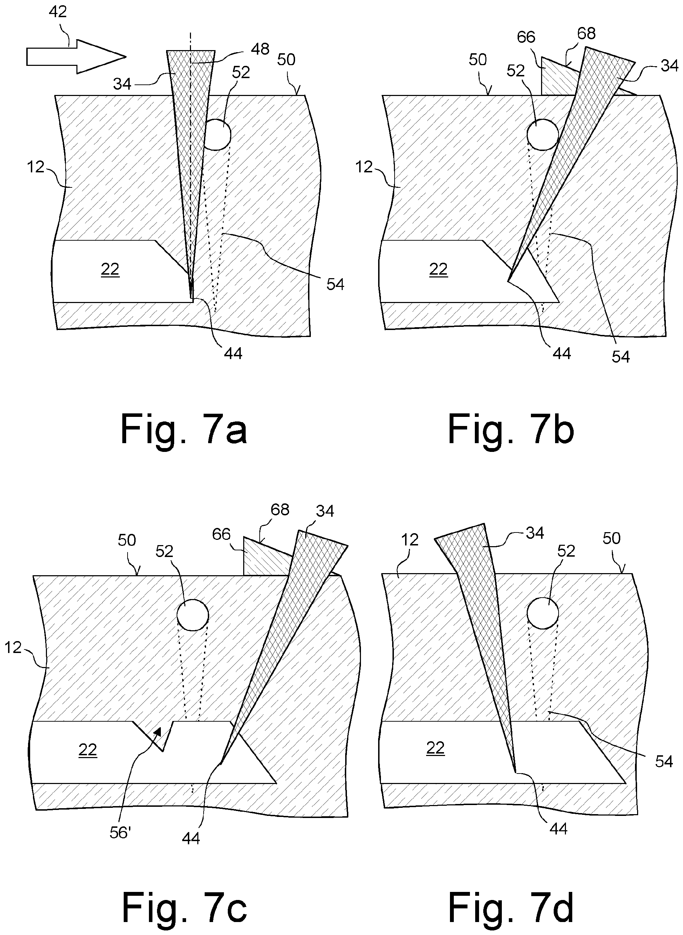

Figure 7a again shows the starting position as in figure 6a. Here, too, the processing is interrupted and the direction of the beam axis 48 is changed for the first time. For this, a wedge 66 which has a wedge face 68 extending obliquely to the surface 50 is placed onto the surface 50. In the exemplary embodiment illustrated, the wedge 66 consists of diamond, which has a refractive index of approximately 2.39. Since this is significantly higher than the refractive index of the substrate material (approximately 1.48), the processing light beam 34 is refracted at the interface between the wedge 66 and the surface 50 not toward the perpendicular, but away from the perpendicular. This makes it possible to direct the processing light beam 34 even further into the shaded area 54 underneath the gas bubble 52; cf. figure 7b.

As shown in figure 7c, the processing in this constellation is continued until the processing light beam 34 is far enough away from the gas bubble 52. The direction of the beam axis 48 is then changed a second time in order to process the region 56', which previously could not be reached by the processing light beam 34. In this processing step, the wedge 66 is not necessary, since the region 56' is far enough away from the shaded area 54. An oblique beam axis 48, as in figure 5a, is sufficient to completely process the region 56'; cf. figure 7d.

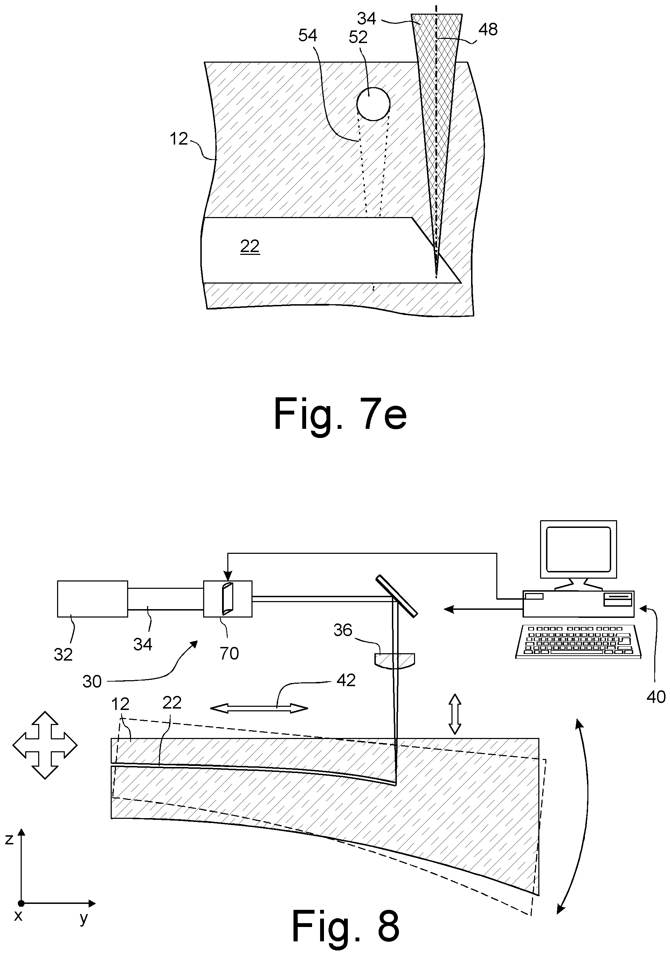

Then, the direction of the beam axis 48 is changed a third time and it is returned to the standard direction, as illustrated in figure 7e.

### 5. Rotationally asymmetrical beam profile

Figure 8 shows a processing device 30 according to another exemplary embodiment. There, changes to the beam direction 48 are made not by tilting the processing light beam 34 but by tilting the mirror substrate 12, as indicated in figure 8 by a dashed line. The displacement stage, on which the mirror substrate 12 is fastened during the processing, must therefore be tiltable about at least one axis of rotation. The adjustment device 38 shown in figure 2 can therefore be omitted.

For this, the processing device 30 has a beam-profile changing device 70, which makes it possible to change the beam profile of the processing light beam 34. In general, the light source 32 generates a processing light beam 34 which has a Gaussian and thus rotationally symmetrical beam profile. Such a beam profile, however, is relatively wide in the process direction 42, and therefore, during the processing, the processing light beam 34 already reaches the gas bubble 52 early, although the focus 44 is still far away from the shaded area 54 (cf. figure 3).

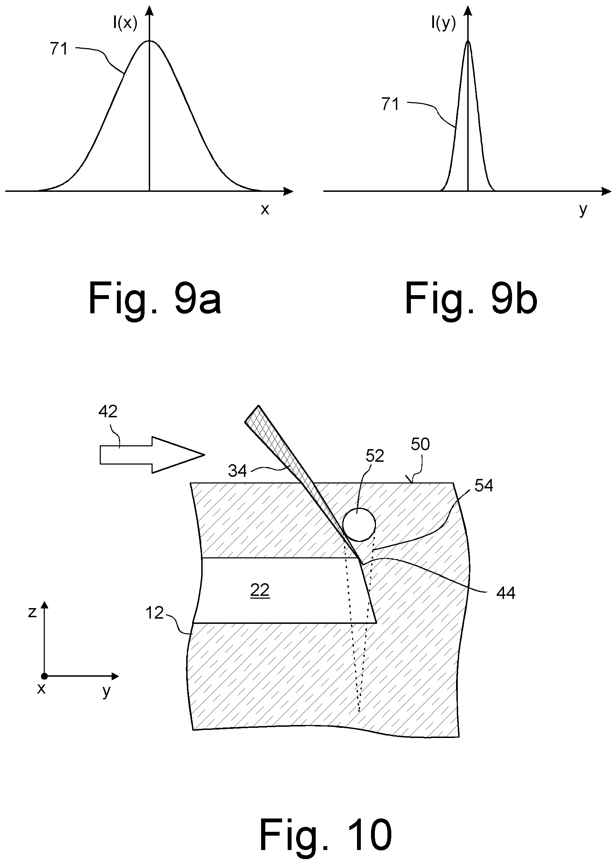

The beam-profile changing device 70 generates a beam profile which is narrower in the process direction 42, which extends parallel to the y direction. Figures 9a and 9b show the beam profile 71 in the xz plane and the yz plane, respectively. They show that the beam profile 71 is significantly narrower in the y direction than in the x direction. The longest diameter of the beam profile (generally, half the width of the Gaussian distribution is assumed to be the diameter) is at least twice its shortest diameter.

If the processing light beam 34 is directed obliquely onto the mirror substrate 12 with such a narrow beam profile in the process direction 42 (i.e. the y direction), as illustrated in figure 10, it is even possible for the processing light beam 34 to reach regions just underneath the gas bubble 52. By contrast, the processing light beam 34 is significantly wider perpendicularly to the plane of the drawing (i.e. in the x direction). Before and after its direction is changed, the beam axis 48 thus lies in a yz plane in which the beam profile has its shortest diameter.

To convert the initially rotationally symmetrical beam profile into the rotationally asymmetrical beam profile according to figures 9a and 9b, the beam-profile changing device 70 can contain multiple cylindrical lenses or other anamorphic optical elements. The use of a diffractive optical element or a spatial light modulator, which makes it possible to establish different beam profiles quickly and flexibly, can also be considered.

### 6. Removal of residues

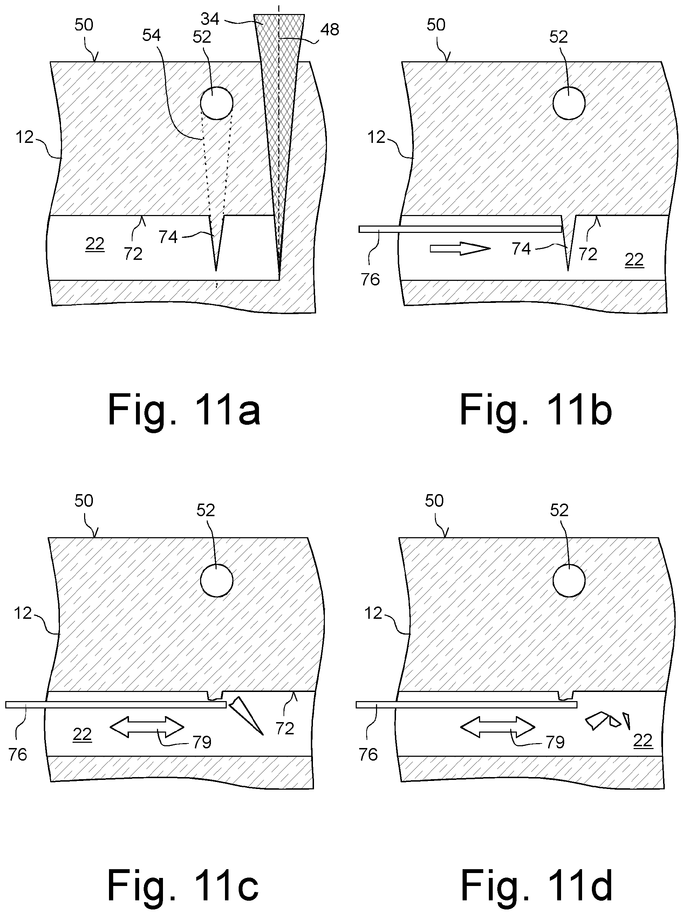

Figure 11a shows an illustration, on the basis of figure 10, of an already produced cooling channel 22 in the mirror substrate 12. However, the inner surface 72 of the cooling channel 22 is not completely smooth and instead has a residue 74. In the exemplary embodiment illustrated, this residue has the form of a spur-like elevation, which extends from one side of the otherwise smooth inner surface 72 of the cooling channel 22 almost to the opposite side of the inner surface 72. The residue 74 thus considerably hinders the throughflow of a cooling liquid.

The residue 74 was caused by a gas bubble 52 located in the vicinity of the surface 50 of the mirror substrate 12. Here, it has been assumed that the beam axis 48 of the processing light beam 34 was not tilted in the way according to the invention. The shaded area 54 which forms downstream of the gas bubble 52 as a result therefore has the effect that the processing light beam 48 cannot reach the substrate material in the region of the residue 74, as illustrated in figure 4.

Even when the method according to the invention is used, in individual cases it is possible that residues 74 remain in the cooling channel 22. If, by contrast to what is illustrated in figure 11a, a gas bubble 52 is located not in the vicinity of the surface 50 but directly above the cooling channel 22, it is difficult for a tilted processing light beam 34 to reach the region 54 shaded by the gas bubble 52.

In order to remove the residue 74, a lance 76 is pushed into the cooling channel 22, as illustrated in figure 11b. In the exemplary embodiment illustrated, the lance 76 is a thin but relatively stiff wire. The wire is just soft enough to be able to follow curvatures in the cooling channel 22 and thus allow the lance to be advanced as far as the residue 74. If the free end 78 of the lance 76 strikes the residue 74, as illustrated in figure 11b, the force exerted by the lance 76 has the effect of breaking off the residue 74; cf. figure 11c. If the residue 74 does not immediately break off or only a small piece breaks off, it can be advantageous to repeatedly move the lance 76 back and forth, as indicated in figure 11c by a double-headed arrow 79. The mechanical action of the lance 76 causes the broken-off part of the residue 74 to fragment into smaller pieces, as shown in figure 11d.

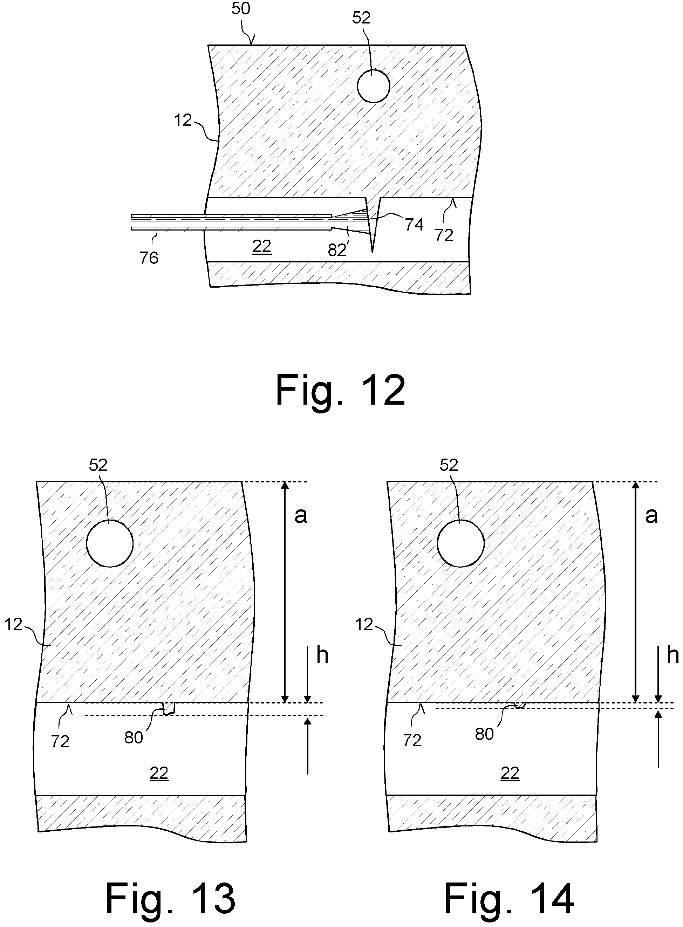

Figure 12 shows a variant in which the lance 76 is in the form not of a wire but of a flexible tube. The flexible tube is connected to a pressure source, not illustrated, which ensures that water 82 or another liquid exits the open end 78 of the flexible tube with pressure surges, as shown in figure 12. In this variant, the residue 74 is not torn off by direct contact with the lance 76 but by the water 82 which exits the flexible tube under pressure.

Figure 13 shows a detail from figure 11c after the residue 74 has been broken off. The breaking edge generally does not lie exactly on the inner surface 72 of the cooling channel 22. The effect of this is that an elevation 80, which protrudes from the otherwise smooth inner surface 72 of the cooling channel 22, remains even after the residue 74 has been removed using the lance 76. The maximum height h of the elevation 80 is, however, small and is between 15 µm and 50 µm, as indicated in figure 13.

If another, chemical processing step follows the mechanical removal using the lance 76, the maximum height h of the elevations 80 can be reduced to values between 15 µm and 25 µm; cf. figure 14.

When the lance 76 is used, the inner surface 72 of the cooling channel 22 is therefore not completely smooth but rather has an elevation 80, with a maximum height h in the specified ranges of values, at locations where a gas bubble 52 or another inclusion has hindered the production of the cooling channel 22 by the processing light beam 34. The gas bubble 52 is between the surface 50 of the mirror substrate 12 and the cooling channel 22. The distance, denoted by a in figures 13 and 14, between the surface 50 and the cooling channel 22 is usually between 20 mm and 30 mm.

### 7. Immersion

As has already been explained in connection with the exemplary embodiment shown in figures 6a to 6d, that surface 50 of the mirror substrate 12 through which the processing light beam 34 passes must be very smooth, in order that a significant proportion of the processing light beam 34 is not lost by scattering at the surface 50. It can be shown that the surface roughness (averaged arithmetically or quadratically) should be considerably less than the wavelength of the processing light beam 34. At typical wavelengths between 350 nm and 2200 nm, the surface 50 must therefore normally be smoothed, before the processing by the processing light beam 34, in a dedicated upstream smoothing step (e.g. polishing or lapping).

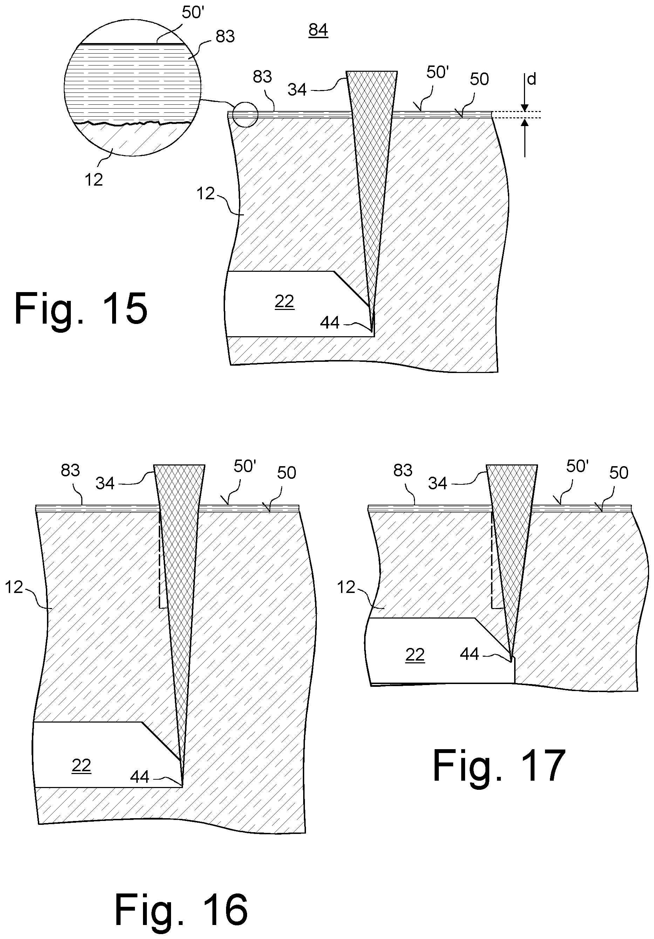

Such a smoothing step can be omitted if the surface 50 is covered with a film of a liquid 83 during the processing by the processing light beam 34, as shown in figure 15. This makes the interface between the liquid 83 and the surrounding air 84 the new surface 50'. Since liquids form a homogeneous and very smooth surface, the processing light beam 34 laser is not scattered there.

Suitable liquids must be transparent to the processing light beam 34. The liquid 83 optimally has a similar refractive index to the mirror substrate 12 (what are referred to as *index matching* liquids). However, it is also possible to use other liquids such as e.g. water, provided they are transparent to the processing light beam 34. If use is made of a liquid 83 having a refractive index that differs from the mirror substrate 12, the offset that arises owing to the refraction must be provided for the positioning of the processing light beam 34.

The liquid 83 is held on the mirror substrate 12 by a border strip, not shown, as a result of which it is prevented from flowing away. The border strip may partially or completely consist of a sealing compound, which is applied to the surface 50 of the mirror substrate 12. After the processing by the processing light beam 34, the sealing compound must be removed again in a cleaning process.

As an alternative, the border strip may be formed by a specifically manufactured component, which can consist e.g. of POM or Teflon and has a form adapted to the surface 50, so that it can be placed on it easily. For surfaces 50 with different forms, components with different component geometries must be provided. Such a component can be reused for this, by contrast with a sealing compound.

The thickness d of the film of liquid should be selected such that the surface 50 of the mirror substrate 12 is completely wetted, i.e. no parts of the substrate 12 should still stick out. A value of approximately 1 µm is regarded as a lower limit for the thickness. The thickness d of the film of liquid is upwardly delimited by the focal length of the focusing lens element 36 and the possible dimensions of the border strip. Depending on the design of the processing device 30, the focusing lens element 36 or the last optical element of the processing device 30 can also come into direct contact with the liquid 83, and this results in a conventional immersion beam path. The processing device may, however, also be separated from the liquid 83 by an air gap.

The selection of the liquid 83 can also be used to change the distance of the focus 44 and/or its size without needing to exchange or adjust the optical unit of the processing device 30. If the refractive index of the liquid 83 is less than that of the mirror substrate 12 (cf. figure 16), the focus 44 is displaced deeper into the mirror substrate 12 than is the case with identical refractive indices (cf. figure 15). If, by contrast, the refractive index of the liquid 83 is higher than that of the mirror substrate 12, the focus 44 is displaced toward the surface 50; cf. figure 17. In addition, the refractive index of the liquid 83 can be used to influence the size of the focus 44.

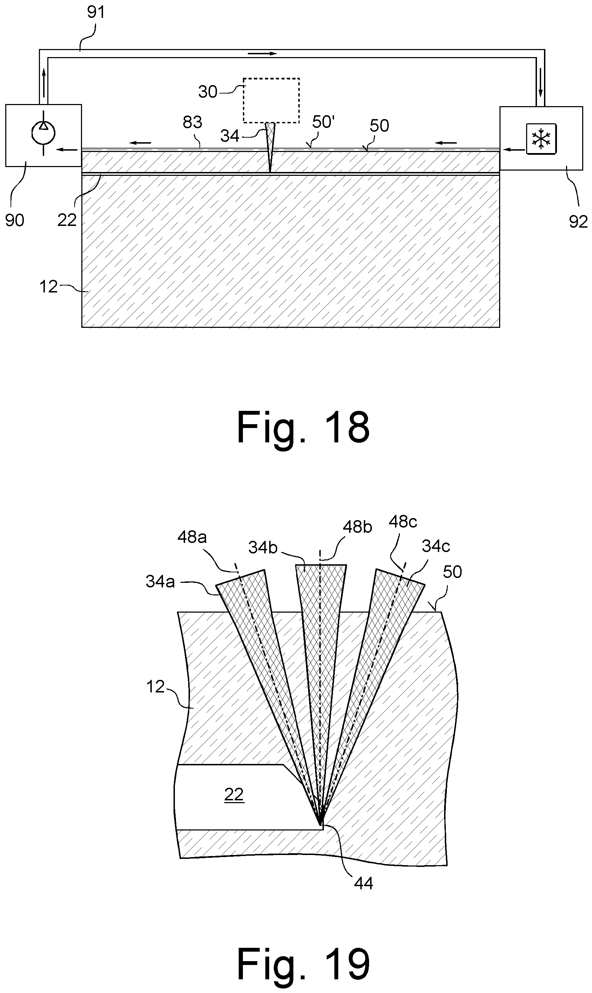

The liquid 83 can also be used to discharge heat generated during the processing from the mirror substrate 12. The prolonged processing by the high-energy processing light beam 34 generates heat by partial absorption of the processing light beam 34 both in the vicinity of the cooling channel 22 and directly on the surface 50 of the mirror substrate. In order to counteract a rise in temperature of the mirror substrate 12, the liquid 83 can be continuously exchanged and have its temperature controlled (e.g. by means of a thermostat), as shown in figure 18. The liquid 83 is circulated by a pump 90 via a return line 91 with short processing interruptions, cooled in a cooling unit 92 and from there discharged onto the surface 50 again. If the pump 90 operates very smoothly, the liquid 83 can also be circulated during the processing by the processing light beam 34.

### 8. Multiple processing light beams

It has been observed that, in certain constellations, the modifications generated by the processing light beam 34 in the substrate material are not restricted to the region in which the cooling channels 22 are to be produced. Since high energy densities are also generated in the interspace between the surface of the mirror substrate 12 and the cooling channel 22, undesired modifications of the substrate material can also occur there. Especially if the cooling channels 22 extend at a very small distance, e.g. 1 mm to 5 mm, from the surface 50, the smallest material modifications can have an impact on the optical function of the mirror.

The energy density in this region of the mirror substrate 12 can be significantly reduced if not a single processing light beam 34 but multiple processing light beams 34, which are directed onto the mirror substrate 12 from different directions, are used to produce the cooling channels 22. The light energy radiated in is then distributed over a much larger volume, as a result of which the energy density is reduced. The processing light beams 34 physically interfere with one another in spatial and temporal terms in the focus 44, with the result that the necessary high energy density is available there.

Figure 19 schematically illustrates this approach. Three processing light beams 34a, 34b, 34c with differently oriented beam axes 48a, 48b and 48c, respectively, are illustrated. It can be seen that the light in the region above the cooling channel 22 is distributed over a larger volume, which is why undesired material modifications can no longer occur there. The beam axes 48a, 48b, 48c meet in the focus 44, with the result that the maximum energy is available there. Each processing light beam 34a, 34b, 34c can thus have a power which is about a third less than the power that would be required with only a single processing light beam 34. Instead of three processing light beams, it is also possible to use 2 or 4 processing light beams. The beam profile of the multiple processing light beams may correspond e.g. to a top hat profile, as explained above. If there are glass bubbles 52 or other inclusions in the path of the processing light beams, the measures described in detail above can be taken.

### 9. Parallel processing

The problem of producing multiple temperature-controlling hollow structures in a substrate or respectively one temperature-controlling hollow structure (or a small number of them) in multiple substrates frequently arises. In order to increase the production economy, according to the invention multiple temperature-controlling hollow structures are produced at the same time.

The simplest solution to this consists in generating multiple processing light beams which are directed onto the substrate at the same time. The processing light beams can then be directed onto the substrate independently of one another by means of an arrangement of small microscanners. However, the currently available equipment of this type does not make it possible to control the processing light beams such that their foci are only a few millimeters apart. However, this is advantageous if e.g. multiple close together, adjacent cooling channels are to be produced. Although such densely arranged foci can be generated in relatively large numbers by means of what are referred to as *photonic drill engines* (PDE), they do not make it possible to control the focus positions independently of one another.

It is therefore proposed to use only one processing light beam, but to guide it over the substrate very quickly using a polygon scanner. Commercially available polygon scanners achieve advancement velocities of up to a few hundred m/s.

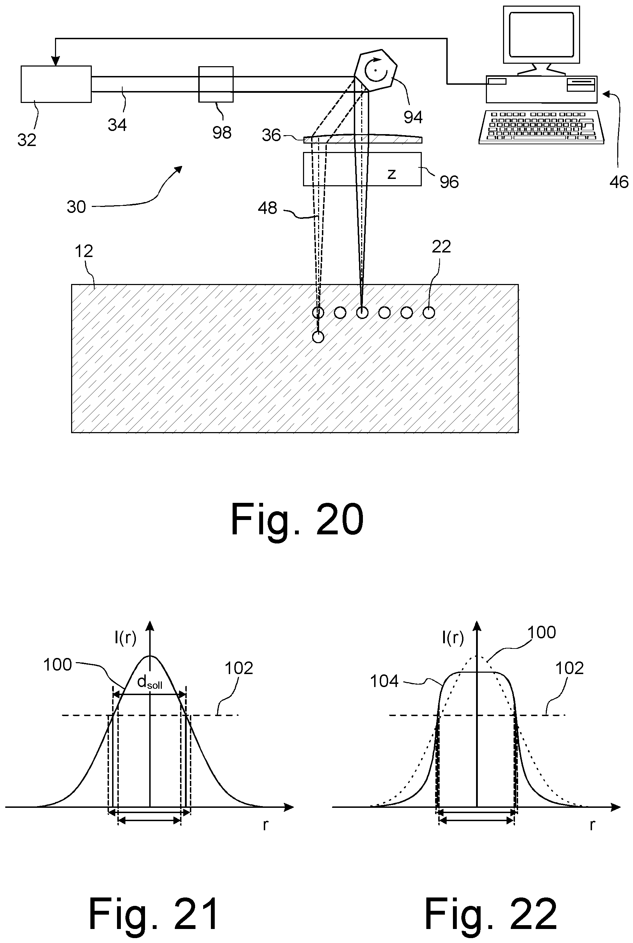

Figure 20 illustrates this in a schematic illustration on the basis of figure 2. If the processing light beam 34 is incident on a quickly rotating polygon mirror 94, it is deflected in different directions, as indicated by a dashed beam path in figure 20. An F-theta objective, indicated with just one focusing lens element 36 here, focuses the processing beam 34 with the beam axis 48 always remaining parallel; this corresponds to a telecentric beam path.

If what is referred to as a z shifter 96 is additionally used, the focus 44 can be freely positioned in a three-dimensional volume without the diameter of the focus 44 changing, as is the case with zoom lenses.

In order that during the scanning movement the processing light beam 34 is not incident on locations that are not to be processed, the processing light beam 34 can pass through a modulator 98, which of the ultra-short light pulses, generated at high frequency, of the light source 32 allows only those that are intended to reach the substrate 12 to pass (what is referred to as *pulse picking*)*,* as is known per se in the prior art.

During operation, the processing light beam 34 roams over the mirror substrate 12 at high speed along a line and is incident there in succession on the cooling channels 22. If the focus 44 traverses an interspace between two adjacent cooling channels 22, the modulator 98 matched to the scanning movement prevents the emission of light pulses. If the line has been completely processed, the processing can be continued at a different height (i.e. z coordinate), this being brought about by a corresponding actuation of the z shifter 96. If the depth range of the z shifter 96 is large enough, it is also possible to produce cooling channels 22 in more than one plane, as shown in figure 20 for the processing light beam 48 indicated in dashed line.

In this way, it is possible to process directly adjacent cooling channels 22 virtually at the same time with only one processing light beam 34, without needing to take into account particular production-related requirements regarding the distances between the cooling channels 22 or the like.

### 10. Changes in the beam profile

It has already been explained above in section 8 in relation to figures 8 to 10 that the beam profile of the processing light beam 34 can be changed using a beam-profile changing device 70, in order to be able to better direct the processing light beam past gas bubbles and other inclusions.

The following text describes further aspects as to how the material processing can be improved in different situations, in particular with and without disruptive influences, by selective modification of the beam profile.

### a) Top hat beam profile

Figure 21 shows the beam profile of the processing light beam 34, i.e. the intensity distribution 1(r) as a function of the radius r, which is measured from the beam axis. If the light source 32 is a laser, the processing light beam 34 has a Gaussian beam profile 100, as shown in figure 21. The processing threshold for the process is plotted by a dashed line 102. The processing threshold 102 specifies the intensity above which the desired modifications occur in the substrate material. The point of intersection of the processing threshold 102 and the beam profile 100 thus establish the width dₛₒₗₗ of the material region modified by the processing light beam 34.

However, it has been found that the processing threshold 102 is not exactly constant in temporal and spatial terms. Causes of this may be, for example, material inhomogeneities in the mirror substrate 12. The oblique flanks of the Gaussian beam profile 100 result in fluctuations of the processing threshold 102 being directly translated into fluctuations of the width of the material region modified by the processing light beam 34, as illustrated in figure 21. If the processing light beam 34 is focused in the mirror substrate 12 with the Gaussian beam profile 100 shown in figure 21, non-uniform cross sections of the cooling channel 22 can therefore occur.

The beam-profile changing device 70 shown in figure 8 therefore converts the Gaussian beam profile 100, as generated by the light source 32, into a top hat beam profile 104, as indicated by a solid line in figure 22. The flanks of the profile are considerably steeper in the case of the top hat beam profile 104 than in the case of the Gaussian beam profile 100, which is indicated in dotted line in figure 22. Local and temporal changes in the processing threshold 102 therefore have less of an effect on the width of the material region modified by the processing light beam 34. A cooling channel 22 produced using the top hat beam profile 104 therefore has a more uniform cross section. Moreover, less energy goes unused with a top hat beam profile 104. The higher efficiency enables higher process speeds and reduces the input of heat into the substrate material.

In order to convert the Gaussian beam profile 100 into the top hat beam profile 104, the radiation energy carried in the processing light beam 34 must be redistributed in a radial direction. To this end, the beam-profile changing device 70 may contain a diffractive optical element (DOE), which changes the angular distribution of the incident processing light beam 34. The desired top hat beam profile 104 is then obtained downstream of the focusing lens element 36, which acts as a Fourier optical unit.

The diffractive optical element is preferably exchangeably received in an exchange holder, with the result that it can be exchanged for a diffractive optical element with different properties.

### b) Donut beam profile

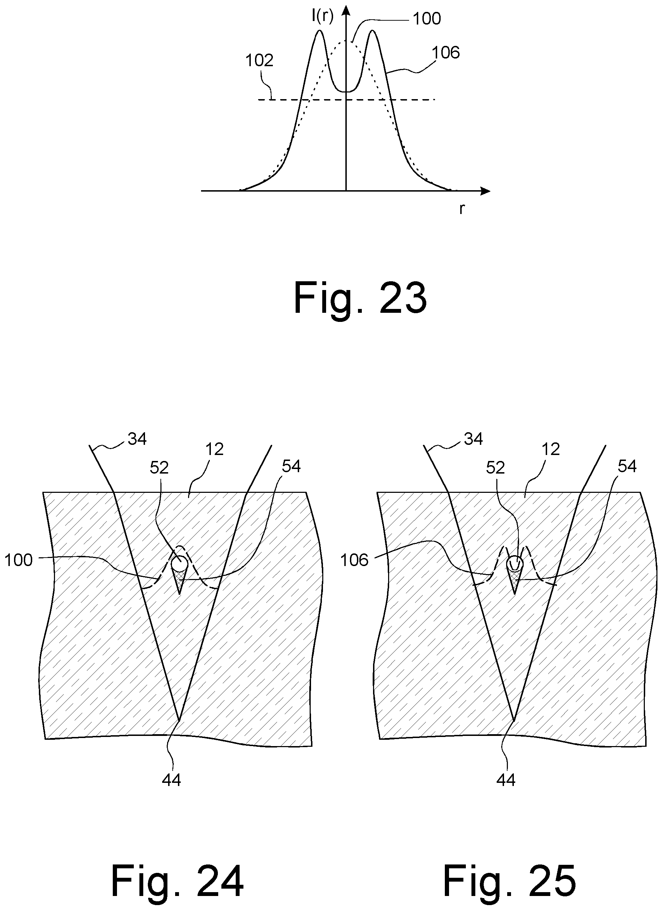

Figure 23 shows a donut beam profile 106, which has been generated by a different diffractive optical element. As the comparison with the Gaussian beam profile 100 shows, in the case of the donut beam profile 106 even more radiation energy is displaced from the center of the processing light beam 34 toward the outside, with the result that there is a drop in intensity on the beam axis. The highest radiation energy is thus reached not on the beam axis, but at a distance from it. The flanks of the profile are also steeper in the case of the donut beam profile 106 than in the case of the Gaussian beam profile 100, with the result that cooling channels 22 with a more uniform cross section are produced.

The donut beam profile 106, however, has additional advantages if gas bubbles or other inclusions are in the light path of the processing light beam 34. Figure 24 schematically shows an enlarged detail of the mirror substrate 12 and the processing light beam 34 that penetrates it and is to be focused in the focus 44. It is assumed that there is a gas bubble 52 in the mirror substrate 12, specifically on the beam axis of the processing light beam 34. As has already been explained in connection with figure 3, the gas bubble 52 acts like a spherical lens, which is why processing light incident on the gas bubble 52 does not reach the focus 44. The gas bubble 52 thus actually results in the shaded area indicated by 54.

If the processing light beam 34 has a Gaussian beam profile 100, as indicated by a dashed line in figure 24, the gas bubble 52 acts such that a larger portion of the energy carried in the processing light beam 34 does not reach the focus 44. As a result, under certain circumstances, the processing threshold 102 is not exceeded, or is only exceeded in a very small region. Consequently, material at individual locations is not modified, and therefore possibly disruptive residues 74 remain in the cooling channels 22.

If, by contrast, the processing light beam 34 has the donut beam profile 106 shown in figure 23, the shading effect of the gas bubble 52 is smaller, as illustrated in figure 25. Since the processing light beam 34 carries relatively little energy on the beam axis, the shading by the gas bubble 52 has a less serious effect on the intensity in the focus 44, thereby resulting in more uniform processing results.

### c) Axicon elements

If the gas bubble 52 is particularly large, the donut beam cross section 106 shown in figure 23 does not offer a drastic improvement either. Such an improvement is only possible if even more light energy is displaced from the beam center toward the outside.

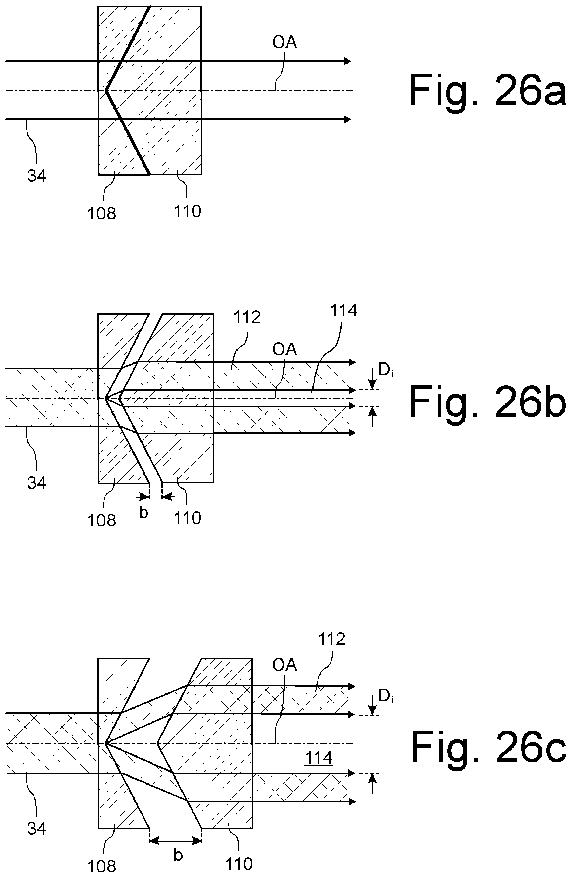

A variably settable radial redistribution of the radiation energy toward the outside is possible if the beam-profile changing device 70 contains a pair of axicon elements 108, 110, as illustrated in figures 26a to 26c. The axicon elements 108, 110 are at a distance b, which can be changed. For this, for example, the second axicon element 110 may be displaceable along the optical axis OA by means of an actuator, which is not illustrated.

In the constellation shown in figure 26a, the two axicon elements 108, 110 make contact, i.e. the distance b is 0. In this configuration, the pair of axicon elements 108, 110 have no effect on the collimated processing light beam 34.

If the second axicon element 110 is displaced to the right by a magnitude b, radiation energy is redistributed from the inside to the outside owing to the light refraction on the conical axicon faces, as illustrated in figure 26b. This produces an annular beam profile, in the case of which a central cylindrical region 112 with a radius rᵢ remains light-free. Should the radius rᵢ be increased, the distance b between the axicon elements 108, 110 is correspondingly increased, as illustrated in figure 26c.

Changing the distance b between the axicon elements 108, 110 thus makes it possible to generate an annular beam profile, in the case of which there is no light at all in a central region 114. The radius rᵢ of the central region 114 can be adapted to the size of the gas bubbles 52.

### d) Beam-profile changing device with micromirror array

Processing of the mirror substrate 12 in the case of which, in the absence of gas bubbles 52 and other inclusions, the processing light beam 34 has the top hat beam profile 104 shown by way of example in figure 22 is preferred. If the mirror substrate 12 is surveyed before the processing, in order to record the locations of the gas bubbles 52, it is possible to predict at what time in the processing process the beam profile of the processing light beam 34 must be changed over from the top hat beam profile 104 shown in figure 22 to the donut beam profile 106 shown in figure 23. While the processing light beam 34 thus inscribes the cooling channel 22 into the mirror substrate 12, the beam profile of the processing light beam 34 repeatedly changes over between the top hat beam profile 104 shown by way of example in figure 22 and the donut beam profile 106 shown by way of example in figure 23.

An exchange of diffractive optical elements in an exchange holder is too slow to be able to carry out the aforementioned changeover between different beam profiles 104, 106. In this case, the beam-profile changing device 70 may contain a micromirror array 116, which makes it possible to change the angular distribution of the processing light beam 34 quickly and flexibly.

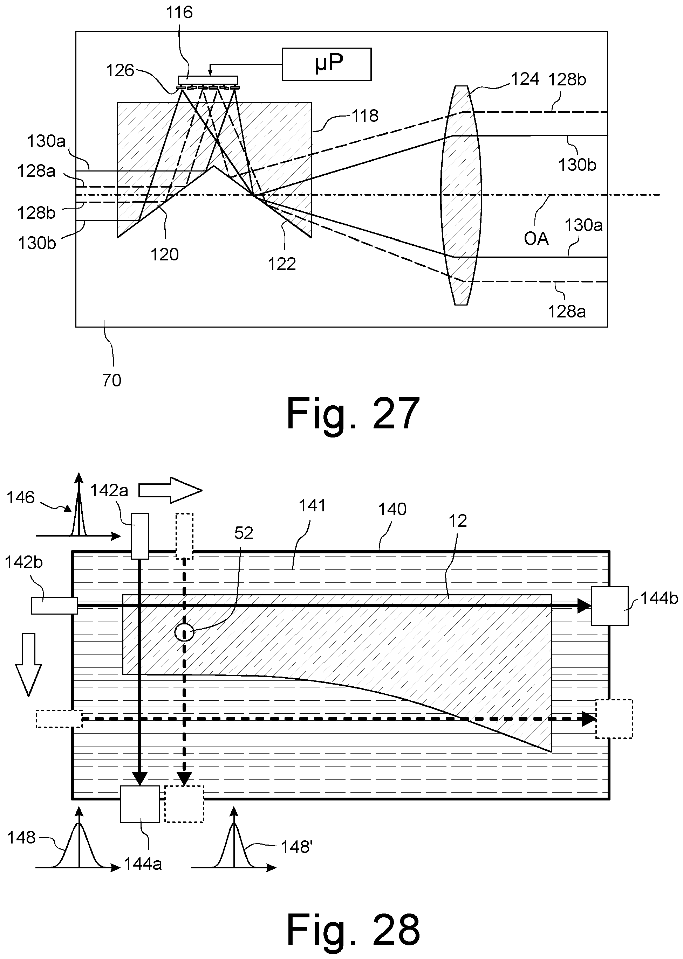

In the exemplary embodiment illustrated in a schematic cross section in figure 27, the beam-profile changing device 70 has an M prism 118, the inclined interfaces 120, 122 of which direct the incident processing light beam 34 onto the micromirror array 116 and the light beams reflected therefrom onto the Fourier lens element 124, which re-collimates the incident light beams. To this end, the micromirror array 116 has a multiplicity of individually tiltable micromirrors 126, which can be tilted continuously by individually settable angles within a predefined angular range.

Figure 27 shows only 5 such tiltable micromirrors 126; in real systems, several hundred or even several thousand micromirrors 126 can be arranged two-dimensionally, as a result of which just about any desired intensity distributions and thus beam profiles can be generated downstream of the Fourier lens element 124.

In the constellation of mirror positions that is shown by way of example in figure 27, for example two light beams 128a, 128b that are on the inside and two light beams 130a, 130b that are on the outside upstream of the micromirror array 116 swap their roles, i.e. the light beams 128a, 128b are on the outside and the light beams 130a, 130b are on the inside downstream of the Fourier lens element 124.

Since it only takes a few milliseconds to reorient the micromirrors 126, the beam-profile changing device 70 shown in figure 27 makes it possible to achieve a very quick changeover of the beam profile during the processing.

### 11. Measurement of the inclusions

A known method that can be used to locate gas bubbles 52 and other inclusions has already been described above. In the case of these known methods, a camera is used to record scattered light caused by the inclusions when light is shone through the mirror substrate 12.

Further methods that make it possible to locate the inclusions even better are explained below.

### a) Ultrashort laser pulses

Figure 28 shows a measuring structure that can be used to locate gas bubbles 52 and other inclusions using ultra-short light pulses.

The measuring structure comprises a trough 140 for receiving the mirror substrate, this trough being filled with a liquid 141 which has a refractive index at least largely corresponding to the refractive index of the mirror substrate 12 to be surveyed. This means that light is not refracted, or is refracted at most to a negligible extent, on the surface of the mirror substrate 12. Especially in the case of irregularly formed mirror substrates 12, this considerably facilitates the measurement. If a liquid 141 is not used, the geometry of the mirror substrate 12 must be surveyed precisely in order to be able to arithmetically take into account the refraction occurring on the surface and any total internal reflection that might occur. Such immersed measurement is also advantageous for other optical measuring methods.

The measuring structure also comprises a first measuring unit having a first light source 142a and a first detector 144a. The first light source 142a may be in the form of e.g. an LED and generates ultrashort broadband light pulses. The center wavelength of the generated light is matched to the mirror substrate and the liquid 141 from the point of view of the highest possible transparency and can be e.g. 2 µm in the case of mirror substrates made of glass ceramic; the pulse duration is preferably between 10 fs and 50 fs.

If such a short light pulse, indicated at 146 in figure 28, passes through the mirror substrate 12 and the surrounding liquid 141, the light pulse is propagated owing to the chromatic dispersion. The propagated light pulse 148 is received by the first detector 144a and then analyzed. The first detector 144a can measure the pulse duration directly for this. As an alternative, the phase front and/or the spectrum of the light pulse 148 can be measured and the pulse duration can be derived therefrom.

In order to survey the entire mirror substrate 12, the first measuring unit is moved relative to the mirror substrate 12 (or the other way around), as indicated by a horizontal arrow in figure 28. This results in a 2D raster at measurement points in a plane perpendicular to the plane of the drawing in figure 28. If there is a gas bubble 52 in the light path at a measurement position, no dispersion occurs in the region of the gas bubble, with the result that the light pulse 148' received by the first detector 144a is propagated to a somewhat lesser extent. There is thus a gas bubble 52 at measurement positions where the propagation is less than usual. From the measurement of the extent to which the propagation deviates at a given measurement position, conclusions can be drawn as to the diameter of the gas bubble 52.

Since it is not known at what longitudinal position of the light path the gas bubble 52 is located, additional measurements along a different direction are necessary. To this end, the measuring structure has a second measuring unit, which has the same design as the first measuring unit and thus has a second light source 142b and a second detector 144b. The second measuring unit is aligned orthogonally to the first measuring unit, in order to be able to survey the mirror substrate in the transverse direction. Correlating the measurements makes it possible to conclude the location of the gas bubble 52 in the mirror substrate 12.

If the liquid 141 and the mirror substrate 12 only absorb the light generated by the light sources 142a, 142b to a small extent, gas bubbles 52 can be measured at all locations of the mirror substrate 12 without high light powers that could result in damage to the substrate material being necessary. The higher the bandwidth of the light pulses 146 is, the greater the propagation of the light pulses 146 owing to dispersion is, and this in turn is associated with an increase in the measurement accuracy. By contrast to the image-based measurement methods mentioned in the introduction, this makes it possible to locate gas bubbles 52 having a diameter of only 50 µm or less.

### b) Incoherent lensless imaging

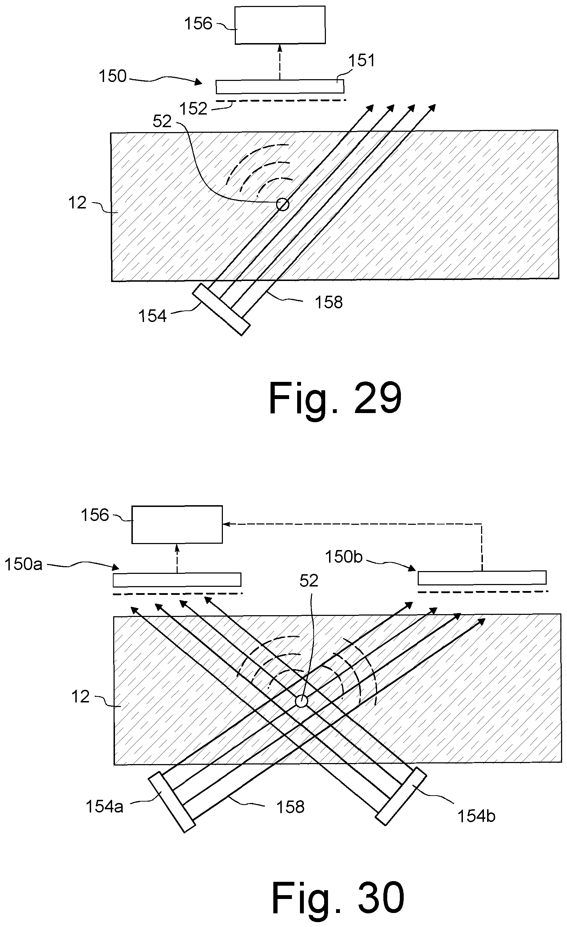

Figure 29 shows a measuring structure which makes it possible to detect gas bubbles 52 and other inclusions by incoherent lensless imaging. Incoherent lensless imaging systems are very inexpensive and require only a detector 150, comprising a normal 2D image sensor 151 and an amplitude mask 152, a light source 154 and an evaluation unit 156. The light source 154, which may be e.g. an LED, generates incoherent light 158 with a wavelength to which the mirror substrate 12 is transparent. The incoherent light 158 is scattered at the gas bubbles 52 and recorded by the detector 150.

As shown in figure 29, the amplitude mask 152 is directly upstream of the image sensor 151, and therefore the detector 150 can have a thickness of less than 1 mm for side dimensions of e.g. 8 mm x 8 mm.

The incoherent lensless imaging method, also known as "FlatScope", is described in detail for example in a essay by Adams JK et al. titled "Single-frame 3D fluorescence microscopy with ultraminiature lensless FlatScope", Sci Adv. 2017 Dec 8;3(12):e1701548. Doi: 10.1126/sciadv.1701548. PMID: 29226243; PMCID: PMC5722650. The FlatScope method is distinguished over already known lensless imaging methods by an optimized arrangement of the stop openings in the amplitude mask 152 which modulates the incoherent point spread function, and therefore high-frequency spatial information can be retrieved.

Moreover, the amplitude mask 152 of the FlatScope method makes it possible to reduce the complexity of the image reconstruction algorithm such that the image can be reproduced from the measurement data from the image sensor 151 virtually in real time. This real-time capability makes it possible to survey the mirror substrate 12 already while the processing light beam 34 is modifying the substrate material at other locations. The measurement results are then integrated in real time in the planning of the further processing sequence.

A further advantage of the FlatScope method is that sharp images can be computed at a wide range of distances without it being necessary to know the distance between the detector 150 and the mirror substrate 12. Mirror substrates 12 with usual dimensions can be surveyed in this way with only a single recording.

In the variant shown in figure 30, the direction of the illumination is varied. Two or more detectors 150a, 150b and two or more light sources 154a, 154b can be used for this. As an alternative, measurements can be taken in succession in order to have time to move a single detector 150 and/or a single light source 154. A variation in the illumination direction is advantageous, because it makes it possible to use the angular dependency of the light scattering on the gas bubbles 52.

### 12. Process monitoring

In order to avoid rejection and/or complex post-processing of the mirror substrates 12, the production of the cooling channels 12 by means of the processing light beam 34 should be monitored continuously. It is possible to measure e.g. the position of the processing light beam 34 relative to the mirror substrate 12 within the scope of such monitoring. This makes it possible to utilize the effect that, in glasses, the processing light beam 34 generates a colorful radiant plasma. A measuring camera that records the plasma then supplies information as to where the processing light beam 34 is in the mirror substrate 12.

It is also possible to consider more complex measuring instruments, such as spectrographs, which make it possible to draw conclusions about the process sequence from the spectrum of the process light generated during the processing. Within the scope of the process monitoring, it is possible to provide, for example, that the process is interrupted when measurement values leave predefined measurement ranges.

The simplest approach is to arrange measuring cameras and other measuring instruments in the half-space that adjoins the surface 50 of the mirror substrate 12 and which also contains the processing device 30. The latter should be aligned in relation to the mirror substrate 12 such that the processing light beam 34 impinges on the polished surface 50 of the mirror substrate 12 with normal incidence.

Although figure 2 is not to scale, it is clear from this illustration that the space available in this half-space is predominantly taken up by the processing device 30. It is therefore difficult to arrange measuring instruments in the vicinity of the processing device 30. This applies all the more to processing devices 30 that generate multiple processing light beams 34 at the same time for parallel processing (cf. section 9 above) and therefore have correspondingly larger dimensions.

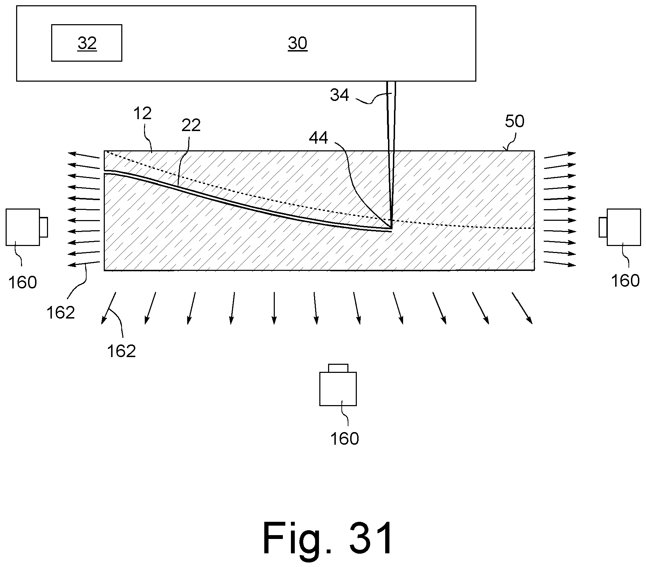

Figure 31 shows a schematic illustration on the basis of figure 2 of the mirror substrate 12 and the processing device 30, which is arranged above it in the half-space and has the light source 32. Also illustrated are three measuring cameras 160, which record the surfaces on two mutually opposite transverse sides and on the back side of the mirror substrate 12 and therefore are arranged outside said half-space. These surfaces are generally not polished, but matte, and therefore the process light exiting from them is scattered and thus can be recorded readily by the measuring cameras 160. The measuring cameras 160 can be used to continuously measure the position of the processing light beam 34 inside the mirror substrate 12 during the laser processing.

Instead of or in addition to the measuring cameras 160, measuring instruments that can be used are photodiodes for measuring the light intensity, spectroscopes for wavelength-resolved recording of the plasma, vibrometers for measuring mechanical vibrations and polarization measuring instruments for measuring material stresses.

The primary advantage of the arrangement shown in figure 31 of measuring instruments on the surface through which the processing light beam does not pass is that more, or bulkier, measuring instruments can be used than is possible in the restricted structural space in the vicinity of the processing device. Conversely, there is more space left for the processing device, in order e.g. to be able to direct even more processing light beams 34 onto the mirror substrate 12 at the same time.

### 13. Projection exposure apparatus

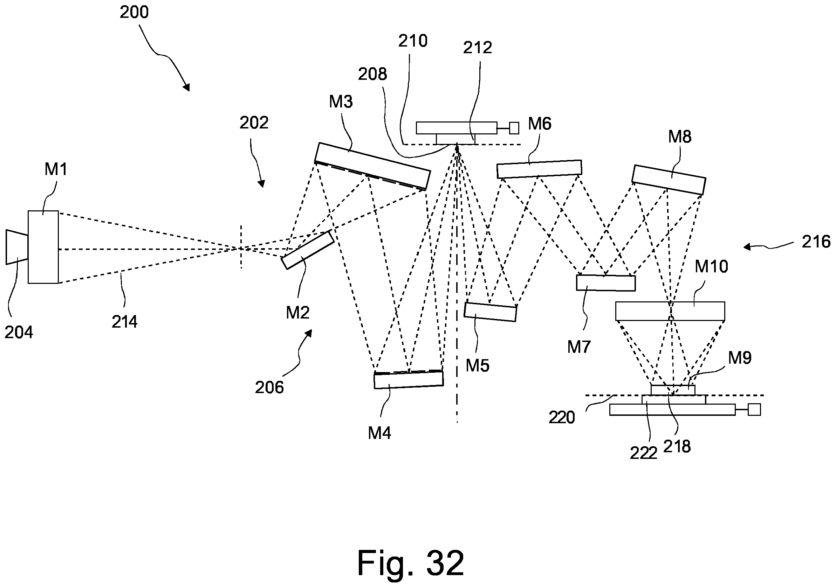

Figure 32 shows a semiconductor technology apparatus on the basis of the example of a projection exposure apparatus 200 for EUV semiconductor lithography. Other semiconductor technology apparatuses such as e.g. a mask inspection apparatus or a wafer inspection apparatus contain components in part identical or similar to those explained here on the basis of the example of the EUV projection exposure apparatus 200.

The projection exposure apparatus 200 comprises an illumination system 202 with a radiation source 204 and an illumination optical unit 206 for illuminating an object field 208 in an object plane 210, in which a reflective reticle 212 is arranged. In the exemplary embodiment illustrated, the radiation source 204 is an EUV radiation source which emits EUV radiation as working radiation 214, in particular in a wavelength range of between 5 nm and 30 nm. The radiation source 204 may be a plasma source, for example an LPP (*laser produced plasma*) source or a GDPP (*gas discharge produced plasma*) source. As an alternative, a synchrotron-based radiation source or a *free electron laser* (FEL) can be used as radiation source 204.

Moreover, the projection exposure apparatus 200 comprises a projection optical unit 216 for imaging the object field 208 into an image field 218 situated in an image plane 220 of the projection optical unit 216. A wafer 222 bearing a light-sensitive layer (referred to as a *resist*) is arranged in the image plane 220. Components for synchronously moving the reticle 212 and the wafer 222 are merely indicated in figure 32 and are not provided with reference signs.

The projection exposure apparatus 200 comprises a plurality of mirrors Mn, which are consecutively numbered in accordance with their arrangement in the beam path of the projection exposure apparatus 200. In the present case, a total of 10 mirrors M1 to M10 are present in the beam path.

The mirrors M3 and M4 are in the form of facet mirrors containing a multiplicity of individual mirrors. Each of the other mirrors Mn is a mirror 10 with a monolithic mirror substrate 12 and a coating 16 borne thereby, as shown by way of example in figure 1. These mirrors are indicated as parallelepipeds in figure 32 for the sake of simplicity. In reality, however, those surfaces of the mirrors 10 that are exposed to the EUV radiation 214 and are provided with the coating 16 are not plane, but curved.

The mirrors M1 to M4 in the illumination system 206 serve to illuminate a portion of the reticle 212 with the desired illumination-angle distribution. The mirrors M5 to M10 of the projection optical unit 216 image this portion onto the wafer 222 in a reduced size. As a result, the structures contained in the reticle 212 are imaged onto the light-sensitive layer borne by the wafer 222.

### 14. Concluding remarks

All the exemplary embodiments, but also individual method steps, concepts or design principles explained above can be combined with one another. For example, firstly gas bubbles 52 can be located by the methods and devices described above under section 11, while processing takes place under immersion using multiple processing light beams 34 according to the methods and devices described above under section 9, as explained above under section 7. The process monitoring can be carried out according to the statements above under section 12. Gas bubbles 52 can be circumvented during the processing by the methods described above under sections 3 to 5; remaining residues can be removed by the methods and devices explained above under section 6.

## Claims

1. A method for producing a temperature-controlling hollow structure in a substrate, in particular in a mirror substrate for a semiconductor technology apparatus, having the following steps:
a) providing the substrate (12), which consists of a substrate material;
b) measuring where inclusions (52) are in the substrate;
c) working the temperature-controlling hollow structure (22) into the substrate (12) by focusing a processing light beam (34) with a beam axis (48) aligned along a standard direction successively onto processing locations (44) at which the temperature-controlling hollow structure (22) is to be produced, as a result of which the substrate material is modified or removed at the processing locations (44);
wherein
in step c), at least if an inclusion (52) measured in step b) is on the beam axis (48) aligned along the standard direction, the direction of the beam axis (48) relative to the substrate (12) is changed such that the beam axis (48) does not intersect the inclusion (50).

2. The method as claimed in claim 1, wherein the temperature-controlling hollow structure is a channel (22) and the standard direction extends at least substantially perpendicularly to a longitudinal axis of the channel (22).

3. The method as claimed in claim 1 or 2, wherein the direction of the beam axis (48) is changed at least twice for every inclusion (52).

4. The method as claimed in claim 3, wherein the temperature-controlling hollow structure (22) is produced along a process direction (42), and wherein a first time the direction of the beam axis (48) is changed, it is changed by a first angle α1 with respect to the standard direction such that the processing light beam (34) is directed underneath the inclusion (52) as seen in the process direction (42), and wherein a second time the direction of the beam axis (48) is changed, it is changed by a second angle α2 with respect to the standard direction such that the processing light beam (34) is directed underneath the inclusion (52) as seen counter to the process direction (42).

5. The method as claimed in one of the preceding claims, wherein, at least once when its beam axis (48) is not aligned parallel to the standard direction, the processing light beam (34) passes through a liquid or solid medium (60; 66) directly adjoining a portion of the surface (50) of the substrate (12) through which the processing light beam (34) passes.

6. The method as claimed in claim 5, wherein the medium (60) is liquid and the portion of the surface (50) of the substrate (12) is inclined such that a horizontal surface, facing toward the surrounding atmosphere, of the liquid medium (60) extends perpendicularly to the incident processing light beam (34).

7. The method as claimed in claim 5, wherein the medium (66) is solid, has a higher refractive index than the substrate (12) and has a surface, facing away from the substrate (12), that extends perpendicularly to the incident processing light beam (34).

8. The method as claimed in claim 7, wherein the medium (66) has the form of a wedge (66) or a truncated wedge.

9. The method as claimed in one of the preceding claims, wherein the processing light beam (34) has a rotationally asymmetrical beam profile (71) when it enters the substrate (12), the longest diameter of the beam profile (71) being at least twice the shortest diameter, and wherein, before and after its direction is changed, the beam axis (48) lies in a plane in which the beam profile (71) has its shortest diameter.

10. The method as claimed in claim 9, wherein the processing light beam (34) passes through an anamorphic optical element before it enters the substrate (12).

11. The method as claimed in one of the preceding claims, wherein residues in the temperature-controlling hollow structure (22) are mechanically broken up.

12. The method as claimed in claim 11, wherein the residues in the temperature-controlling hollow structure (22) are broken up by inserting a lance (76) into an already produced temperature-controlling hollow structure (22) or, while a temperature-controlling hollow structure (22) is being produced, into the substrate.

13. The method as claimed in claim 11, wherein, after or during the insertion of the lance (76), the temperature-controlling hollow structure (22) is rinsed with a chemically active medium, as a result of which the residues (74) are removed further.

14. A substrate (12) having a temperature-controlling hollow structure (22) which has a smooth inner surface (71), the substrate (12) consisting of glass or a glass ceramic and having at least one inclusion (52), wherein the inner surface (71) has a locally delimited elevation (80) which does not contribute to the function of the temperature-controlling hollow structure (22) and has a height h of between 15 µm and 50 µm.

15. The substrate as claimed in claim 14, wherein the maximum height of the elevation (80) is smaller than 25 µm.

16. The substrate as claimed in either of claims 14 and 15, wherein the temperature-controlling hollow structure (22) has a surface area of at least 2 mm x 50 cm.

17. The substrate as claimed in one of claims 14 to 16, wherein a distance between the temperature-controlling hollow structure (22) and a surface (50) of the substrate is between 20 mm and 50 mm, and wherein the inclusion (52) is between the surface (50) and the temperature-controlling hollow structure (22).

18. A mirror (10) having a substrate (12) as claimed in one of claims 14 to 17 and having a coating (16) borne by a support surface (14) of the substrate (12).

19. The mirror as claimed in claim 18, wherein the temperature-controlling hollow structure extends at a distance from 1.0 mm to 50.0 mm, from 1.0 mm to 20.0 mm, from 1.0 mm to 10.0 mm or from 1.0 mm to 5.0 mm from the support surface (14).

20. The mirror as claimed in claim 18 or 19, wherein the inclusion (52) is between the support surface (14) and the temperature-controlling hollow structure (22).

21. A mirror having a temperature-controlling hollow structure (22) which has a smooth inner surface (71), the substrate (12) consisting of glass or a glass ceramic, wherein the inner surface (71) has a locally delimited elevation (80) which does not contribute to the function of the temperature-controlling hollow structure (22) and has a height h of between 15 µm and 50 µm, and wherein the temperature-controlling hollow structure (22) extends at a distance from 1.0 mm to 50.0 mm, from 1.0 mm to 20.0 mm, from 1.0 mm to 10.0 mm or from 1.0 mm to 5.0 mm from the support surface (14).

22. A semiconductor technology apparatus having a mirror as claimed in one of claims 18 to 21 and/or having a substrate as claimed in one of claims 14 to 17 and/or having a substrate produced by a method as claimed in one of claims 1 to 13.
